# EUROPÄISCHE PATENTSCHRIFT

(11) **EP 4 341 654 B1**
(45) Veröffentlichungstag und Bekanntmachung des Hinweises auf die Patenterteilung: **11.03.2026**
(21) Anmeldenummer: 22727252.3
(22) Anmeldetag: 17.05.2022
(51) Int. Cl.: G01H 1/00, G01H 11/08, G01M 5/00, H02N 2/06, H10N 30/00

(54) **POSITIONIERVORRICHTUNG UND VERFAHREN ZUM BETREIBEN EINER SOLCHEN POSITIONIERVORRICHTUNG**
POSITIONING DEVICE AND METHOD FOR OPERATING SUCH A POSITIONING DEVICE
DISPOSITIF DE POSITIONNEMENT ET PROCÉDÉ DE FONCTIONNEMENT DUDIT DISPOSITIF DE POSITIONNEMENT

(30) Priorität: 18.05.2021 DE 102021112809
(43) Veröffentlichungstag der Anmeldung: 27.03.2024
(73) Patentinhaber: Physik Instrumente (PI) SE & Co. KG, 76228 Karlsruhe (DE)
(72) Erfinder: WISCHNEWSKI, Alexej, 76744 Wörth (DE)
(74) Vertreter: Keller Schneider Patentanwaltsgesellschaft mbH
(86) Internationale Anmeldenummer: PCT/DE2022/100369
(87) Internationale Veröffentlichungsnummer: WO 2022/242798

(56) Entgegenhaltungen:
- EP-A1- 1 752 642
- EP-A2- 0 919 987
- DE-B3- 102018 104 928
- US-B2- 11 114 954

## Beschreibung

Die Erfindung betrifft eine Positioniervorrichtung nach Anspruch 1 sowie ein Verfahren zum Betreiben einer solchen Positioniervorrichtung nach Anspruch 9.

Eine piezoelektrisch angetriebene Positioniervorrichtung ist aus der EP 1 752 642 A1 bekannt. Piezoelektrisch angetriebene Positioniervorrichtungen ermöglichen eine Feinpositionierung in Bereichen von einigen Zehntel Pikometern bis hin zu mehreren Zentimetern. Als Stellglieder werden bei diesen mechanischen Systemen insbesondere piezoelektrische Mehrschichtaktuatoren eingesetzt. Piezoelektrische Aktuatoren sind elektromechanische Energiewandler, deren Funktionsprinzip auf Formänderung bestimmter Kristalle unter dem Einfluss eines elektrischen Feldes beruht. Die Aktuatoren bestehen aus piezoelektrischen Einkristallen, aus piezoelektrischer monokristalliner Keramik oder aus piezoelektrischen Polymer-Verbundwerkstoffen.

Piezoelektrisch angetriebene Positioniervorrichtungen werden u.a. in hochkomplexen und daher kostenintensiven Anlagen eingesetzt, beispielsweise in Lithographiemaschinen oder optischen Sternteleskopen. Die mehrschichtigen Aktuatoren arbeiten zwar überwiegend quasistatisch, d.h. weit unterhalb von der niedrigsten Resonanz des Systems; trotzdem sind sie sowie die üblicherweise in solchen Positioniervorrichtungen eingesetzten Festkörpergelenke, über welche der Vorschub des anzutreibenden Elements durch deren elastische Verformung realisiert wird, einer ständigen mechanischen Beanspruchung ausgesetzt. Die Kontraktion und Expansion des Aktuators bzw. die Biegung der Festkörpergelenke kann im Betrieb bis zu 20.000mal pro Sekunde erfolgen. Mit zunehmender Betriebszeit können in den Aktuatoren, Führungen, Gelenken oder anderen Komponenten der Mikropositioniervorrichtung Mikrorisse, Kurzschlüsse, Delaminierungen oder sonstige Defekte auftreten, die den Betrieb der Vorrichtung negativ beeinträchtigen können bis hin zu einem Totalausfall. Ein plötzlicher Ausfall der Positioniervorrichtung versursacht dabei in der Regel hohe Kosten.

Die meisten der vorgenannten Defekte treten normalerweise nicht plötzlich auf, sondern entwickeln sich mit der Zeit, ausgehend von einem nur geringfügigen Anfangsdefekt, und pflanzen sich dann fort. Jedes mechanische System weist ein spezifisches Resonanzbild auf, welches von der Form, den geometrischen Abmessungen, den Werkstoffeigenschaften etc. einzelner Systemkomponenten abhängt. Defekte verursachen eine Veränderung des Resonanzbildes eines Systems. Das Entstehen von Resonanzen, die zuvor nicht vorhanden waren bzw. eine Veränderung oder eine Eliminierung von den in dem System zuvor vorhandenen Resonanzen weisen auf ein Entstehen von Defekten hin.

Aus der US 3,720,098 ist ein Verfahren zum zerstörungsfreien Messen von Materialeigenschaften eines Objektes mittels Ultraschallwellen bekannt. Hierzu werden mit Hilfe eines Senders Ultraschallwellen in das zu untersuchende Objekt induziert und mit Hilfe eines Empfängers ihre Ausbreitungszeit gemessen. Durch Analyse der Ultraschallwellenausbreitung in dem Objekt werden Rückschlüsse auf seine Materialeigenschaften erhalten.

Der wissenschaftliche Artikel 'Rapid Nondestructive Testing of Ceramic Multilayer Capacitors' von O. Boser, P. Kellawon, R. Geyer in IEEE Transactions on Components, Hybrids and Manufacturing Technology, Vol. 12, No. I, 1989 beschreibt ein Verfahren zum zerstörungsfreien Detektieren von Rissen, Delaminierungen oder anderen Defekten in einem mehrschichtigen piezokeramischen Kondensator. Das Verfahren basiert auf der Anregung von stehenden Ultraschallwellen in dem Kondensator. Die Aufnahme der Impedanz des Kondensators wird mit einem Labor-Impedanzanalysator HP Model 4192A durchgeführt. Es wird gezeigt, dass eine Veränderung im Impedanzbild eines Mehrschichtkondensators ein Beweis für einen inneren Defekt im Kondensator ist.

Aus dem wissenschaftlichen Artikel 'Impedance Spectroskopy of Piezoelectric Actuators' von C.R. Bowen, M. Lopez-Prieto, S. Mahon, F. Lowrie in: Scripta mater, 42 (2000), 813-818, ist ein Verfahren zum zerstörungsfreien Detektieren von Rissen, Delaminierungen oder anderen Defekten in einem mehrschichtigen piezoelektrischen Aktuator bekannt. Dabei wird die Veränderung im Resonanzbild des Aktuators infolge der inneren Defekte untersucht. Hierzu wird ein Impedanzspektrum des Aktuators mit den direkten Messungen mittels eines optischen sowie eines Scanner-Elektronmikroskops verglichen. Die Aufnahme der Impedanz wird mit Hilfe eines Labor-Impedanzanalysators (Solartron 1260) von unterhalb bis oberhalb der Aktuatorresonanz durchgeführt. Es wird bestätigt, dass es durch Untersuchung der Impedanz des piezoelektrischen Mehrschichtaktuators möglich ist, Defekte innerhalb des Aktuators schnell und zerstörungsfrei zu erkennen.

Die US2010/0013352 A1 beschreibt ein System zur Analyse und Unterdrückung von unerwünschten Schwingungen in diversen Maschinen, beispielsweise Turbinen, Motoren oder Robotern. Das System beinhaltet eine Anzahl von piezoelektrischen Schwingungssensoren, Aktuatoren zur Erzeugung von Schwingungen sowie ein mit den Sensoren sowie Aktuatoren verbundenen Controller. Die gemessenen Schwingungen werden mittels einer Rückkopplung an den Controller übermittelt, der dann das Ansteuerungssignal für die Aktuatoren dynamisch verändert. Zur Unterdrückung der unerwünschten Schwingungen steuert der Controller die Aktuatoren entsprechend einem Schwingungsunterdrückungsalgorithmus an.

Aus der EP 1 735 586 B1 ist eine Vorrichtung zur zerstörungsfreien Erkennung von struktureller Beschädigung bekannt. Die Vorrichtung beinhaltet einen piezoelektrischen Sensor sowie einen Aktuator. Der Aktuator erzeugt in der zu untersuchenden Struktur akustische Wellen. Der Sensor empfängt die von der Struktur reflektierten Wellen. Eine Auswertung des Sensorsignals lässt auf das Vorhandensein von Strukturbeschädigungen schließen.

Die Aufgabe der Erfindung besteht in der Bereitstellung einer Positioniervorrichtung, bei der eine Vorhersage bzw. Erfassung von entstehenden Defekten innerhalb der Positioniereinheit ermöglicht ist, und in der Bereitstellung eines Verfahrens zum Betreiben einer solchen Positioniervorrichtung, um Defekte innerhalb der Positioniereinheit vorherzusagen bzw. zu erfassen. Dies ermöglicht insbesondere ein rechtzeitiges Ersetzen entsprechender Komponenten der Positioniereinheit, bevor es im ungünstigsten Fall zu deren Totalausfall kommt.

Die erfindungsgemäße Positioniervorrichtung umfasst eine Positioniereinheit sowie einen Controller. Die Positioniereinheit wiederum umfasst wenigstens einen piezoelektrischen und vorzugsweise mehrschichtigen Aktuator, welcher der Bewegung eines Antriebselement dient, wobei die Bewegung des Antriebselements durch gezielte mechanische Deformationen des zumindest einen Aktuators hervorgerufen wird und die Bewegung des Antriebselements zum Antrieb bzw.zur Positionierung eines zu positionierenden Elements vorgesehen ist. Die Positioniervorrichtung weist auf: Die Positioniervorrichtung weist auf: eine Positioniereinheit, die einen piezoelektrischen Aktuator aufweist, ein durch den Aktuator bewegbares Antriebselement, das zur Kopplung mit einem zu positionierenden Element vorgesehen ist, und einen Controller, wobei die Positioniervorrichtung eine Defektanalysevorrichtung zum Erfassen von Defekten in der Positioniereinheit aufweist, wobei im Falle, dass die Positioniereinheit einen einzigen Aktuator aufweist, dieser einen Generator und einen Empfänger akustischer Ultraschallwellen umfasst, und im Falle, dass die Positioniereinheit mehrere Aktuatoren aufweist, wenigstens einer der Aktuatoren zumindest einen Generator akustischer Ultraschallwellen umfasst und wenigstens ein anderer der Aktuatoren zumindest einen Empfänger akustischer Ultraschallwellen umfasst, und die Defektanalysevorrichtung einen Messsignalgenerator zur Erzeugung eines Messsignals in Form einer elektrischen Wechselspannung zur Anregung des oder eines Generators aufweist, wobei die Defektanalysevorrichtung einen Resonanzanalysator für die Analyse eines von dem oder einem Empfänger erzeugten elektrischen Signals aufweist, wobei der Resonanzanalysator zur Vorhersage oder zum Erfassen von Defekten in der Positioniereinheit derart konfiguriert ist, dass dieser aus dem Vergleich eines Resonanzbilds der Positioniereinheit vor dem normalen Betrieb mit einem Resonanzbild der Positioniereinheit während des normalen Betriebs die Entstehung von neuen oder das Verschwinden oder die Veränderung von zuvor existierenden Resonanzen erfasst und analysiert, wobei der Resonanzanalysator konfiguriert ist, den Vergleich des Resonanzbilds vor dem normalen Betrieb mit einem Resonanzbild während des normalen Betriebs nach einer der folgenden Alternativen (A), (B), (C), (D), (E) auszuführen: (A) der Messsignalgenerator ist derart konfiguriert, dass dieser zur Ermittlung der Resonanzen, die zuvor vorhanden und jetzt verschwunden sind oder sich geändert haben, eine elektrische Sinusspannung erzeugt, deren Frequenz sich periodisch von einem Anfangs- zu einem Endwert ändert; (B) der Messsignalgenerator ist derart konfiguriert, dass der Frequenzwert des Messsignals gleich einem messbaren Resonanzfrequenzwert eines Aktuators ist, wobei die Resonanzfrequenz zu den verschiedenen Arten von akustischen Ultraschallwellen gehört und wobei nach einem kurzen Anregen eines Generators auf der Resonanzfrequenz das Abklingen der Positioniereinheit über einen Empfänger aufgenommen und danach zwecks Erfassung einer Resonanzveränderung die aufgezeichnete Abklingkurve mit einer zu einer früheren Zeit aufgenommenen Abklingkurve verglichen wird; (C) der Messsignalgenerator ist derart konfiguriert, dass der Frequenzwert des Messsignals gleich einem messbaren Resonanzfrequenzwert der Positioniereinheit ist, wobei nach einem kurzen Anregen eines Generators das Abklingverhalten der Positioniereinheit zwecks Erfassung einer Resonanzveränderung aufgezeichnet und mit einem zu einer früheren Zeit aufgenommenen Abklingverhalten verglichen wird; (D) der Messsignalgenerator ist derart konfiguriert, dass der Frequenzwert des Messsignals gleich mindestens einem messbaren Resonanzfrequenzwert der Positioniereinheit ist, wobei während des Anregens eines Generators zwecks Erfassung mindestens einer Resonanzveränderung der innere Widerstand Ri=UA/IA der Positioniereinheit bestimmt und mit einem zu einer früheren Zeit aufgenommenen Wert des inneren Widerstands der Positioniereinheit verglichen wird; (E) der Messsignalgenerator ist derart konfiguriert, dass der Frequenzwert des Messsignals im Wesentlichen gleich einem messbaren Resonanzfrequenzwert der Positioniereinheit ist, und dabei während oder nach einem kurzen Anregen eines Generators der reflektierte Impuls von einem Empfänger aufgenommen wird, wobei Parameter des reflektierten Impulses zwecks Erfassung einer Resonanzveränderung aufgezeichnet und mit zu einer früheren Zeit aufgenommenen Parametern verglichen werden.

Zur Übertragung der Bewegung des Antriebselements auf das zu positionierende Element ist eine Kopplung zwischen dem Antriebselement und dem zu positionierenden Element vorgesehen. Diese Kopplung kann beispielsweise eine starre mechanische Verbindung sein, so dass es zu einer direkten Umsetzung der Bewegung des Antriebselements auf das zu positionierende Element kommt. Die Kopplung kann jedoch auch als Friktionskontakt und insbesondere als intermittierender Friktionskontakt zwischen dem Antriebselement und dem zu positionierenden Element realisiert sein, bei dem zeitweise, d.h. während eines Antriebsschritts, ein Reib- oder Friktionskontakt zwischen dem Antriebselement und dem zu positionierenden Element vorliegt und in diesem Zeitabschnitt eine mechanische Kopplung über einen Reib- oder Friktionskontakt vorliegt. Einem jeweiligen Antriebsschritt folgt dann zeitlich eine Phase, in welcher das Antriebselement zu einer Ausgangsposition zurückkehrt, wodurch der nächste Antriebsschritt vorbereitet wird.

Im Falle, dass die Positioniereinheit einen einzigen Aktuator aufweist, ist dieser zusätzlich zu seiner Antriebsfunktion dazu ausgebildet bzw. eingerichtet, sowohl als Generator, als auch als Empfänger von akustischen Ultraschallwellen zu wirken bzw. zu fungieren. Im Falle, dass die Positioniereinheit mehrere, d.h. wenigstens zwei, Aktuatoren aufweist, ist wenigstens einer der Aktuatoren dazu ausgebildet, zumindest als Generator akustischer Ultraschallwellen zu wirken bzw. fungieren, und wenigstens ein anderer der Aktuatoren ist dazu ausgebildet, zumindest als Empfänger akustischer Ultraschallwellen zu wirken bzw. zu fungieren.

Mit anderen Worten weist die erfindungsgemäße Positioniervorrichtung bzw. deren Positioniereinheit entweder nur einen piezoelektrischen und vorzugsweise mehrschichtigen Aktuator, der dann neben seiner Funktion zum Bewegen des Antriebselements gleichzeitig als Generator und als Empfänger akustischer Ultraschallwellen fungiert und damit die Funktionen als Antrieb, Generator und Empfänger in sich vereint, oder mehrere, d.h. wenigstens zwei, piezoelektrische und vorzugsweise mehrschichtige Aktuatoren auf, von denen entweder nur einer, oder mehrere oder alle neben der Funktion zum Bewegen des Antriebselements gleichzeitig als Generator und als Empfänger akustischer Ultraschallwellen fungiert bzw. fungieren. Daneben ist es möglich, dass im Falle, dass die Positioniervorrichtung bzw. die Positioniereinheit mehrere Aktuatoren aufweist, einer oder mehrere der Aktuatoren neben der Antriebsfunktion nur als Generator akustischer Ultraschallwellen fungiert bzw. fungieren, und ein anderer Aktuator oder mehrere andere Aktuatoren neben der Antriebsfunktion nur als Empfänger akustischer Ultraschallwellen fungiert bzw. fungieren, so dass die Funktionen Antrieb plus Generator und Antrieb plus Empfänger auf wenigstens zwei unterschiedliche und räumlich voneinander getrennte Aktuatoren aufgeteilt sind.

Wenn sich nachfolgende Teile der Beschreibung oder die Ansprüche auf ,einen Aktuator' oder ,den Aktuator' (d.h. Einzahl) beziehen, dann ist dies nicht einschränkend auf einen einzelnen Aktuator zu verstehen. Vielmehr ist die Verwendung der Einzahl in Zusammenhang mit dem Begriff ,Aktuator' (also 'ein Aktuator' oder ,der Aktuator') so zu verstehen bzw. auszulegen, dass die mit dem Aktuator in Beziehung stehenden Merkmale entweder nur auf den einzelnen Aktuator zutreffen, oder im Falle von mehreren Aktuatoren auf alle oder nur einen Teil davon oder nur einen davon zutreffen. Sollte beispielsweise eine Anordnung eines Aktuators beschrieben sein, dann bezieht sich diese Anordnungsbeschreibung entweder, d.h. im Falle des Vorliegens eines einzigen Aktuators, auf eben diesen einzelnen Aktuator, oder, d.h. im Falle des Vorliegens von mehreren Aktuatoren, auf einen der Aktuatoren, auf alle der Aktuatoren oder aber nur auf einen Teil der Aktuatoren oder aber nur auf einen der Aktuatoren. Das Vorstehende gilt in identischer Weise für die Verwendung der Begriffe 'ein Generator' und 'ein Empfänger' hierin.

Der hierin verwendete Begriff ,oder' ist - sofern nicht explizit anders angegeben - als inklusives Oder, d.h. als nicht-ausschließende Disjunktion, zu verstehen. In diesem Zusammenhang ist etwa der Term ,der Aktuator hat die Funktion eines Generators oder eines Empfängers' hierin so zu verstehen, dass der Aktuator die Funktion eines Generators oder die Funktion eines Empfängers hat oder aber dass der Aktuator die Funktion eines Generators und eines Empfängers hat.

Die Funktion des mechanischen Stellglieds in der Positioniereinheit übernimmt dabei der Aktuator oder die Aktuatoren, wobei die Zahl der verwendeten Aktuatoren in erster Linie durch den Anwendungsfall bestimmt ist. Neben der Funktion eines Stellgliedes hat bei Vorliegen eines einzelnen Aktuators dieser - neben seiner Antriebsfunktion - sowohl die Funktion eines Generators, als auch die eines Empfängers von akustischen Ultraschallwellen. In diesem Falle, d.h. bei Vorliegen eines einzelnen bzw. einzigen Aktuators, beinhaltet dieser sowohl den Generator, als auch den Empfänger von akustischen Ultraschallwellen. Die Funktion des Generators ist das Erzeugen von akustischen Ultraschallwellen, während es die Funktion des Empfängers ist, die akustischen Ultraschallwellen zu empfangen.

Der Aktuator ist beispielsweise zwischen Festkörpergelenken angeordnet und über diese mit dem Antriebselement verbunden bzw. gekoppelt. Die Bewegung bzw. Deformation des Aktuators wird hierbei auf das Antriebselement durch elastische Verformung der Festkörpergelenke übertragen.

Im Falle eines mehrschichtigen Aktuators ist dieser aus mehreren Schichten aufgebaut, wobei jede Schicht aus zwei Elektroden sowie einem zwischen den Elektroden angeordneten polarisierten piezoelektrischen Werkstoff besteht. Man spricht in diesem Zusammenhang auch von einem Multilayeraktuator.

Der Controller umfasst einen Steuer-Regelcontroller des Aktuators bzw. der Positioniereinheit, eine Defektanalysevorrichtung, von der der Generator akustischer Ultraschallwellen angeregt und von dem das Signal des Empfängers akustischer Ultraschallwellen aufgezeichnet und analysiert wird, sowie optional einen Kommutator. In dem optionalen Kommutator findet ein Umschalten zwischen einem aktuatorischen Betrieb des Aktuators (d.h. zur Erzeugung einer Bewegung bzw. Deformation desselben) und einem sensorischen Betrieb des Aktuators als Generator oder als Empfänger statt. Außerdem kann der Controller eine Schnittstelle zu einem Computer mit einem Bildschirm aufweisen, an dem die Defektanalyse visuell durch eine Person vorgenommen werden kann.

Der Steuer-Regelcontroller beinhaltet eine Leistungsendstufe für den Aktuator, einen Trajektorien- und Signalgenerator, einen Positionsregler zur Regelung der Position sowie optional der Geschwindigkeit oder der Beschleunigung der Positioniereinheit.

Die Defektanalysevorrichtung hat die Funktionen, den Aktuator bzw. die Positioniereinheit zu steuern und/oder zu regeln, den bzw. einen Generator von akustischen Ultraschallwellen mit einem Messsignal anzuregen sowie das von dem bzw. einem Empfänger der akustischen Ultraschallwellen kommende Signal zu verarbeiten. Die Defektanalysevorrichtung umfasst zumindest einen Messsignalgenerator zur Erzeugung einer elektrischen Sinusspannung und einen Resonanzanalysator für die Analyse eines von einem als Empfänger fungierenden Aktuators erzeugten Signals.

Als piezoelektrischer Werkstoff für den Aktuator kann ein monokristallines piezoelektrisches Material, eine polykristalline piezoelektrische Keramik, ein piezoelektrischer Polymerwerksoff oder ein anderes piezoelektrisches oder elektrostriktives Material verwendet sein. Die Positioniereinheit kann einen oder mehrere, vorzugsweise mehrschichtige Aktuatoren beinhalten. Bei Verwendung von Festkörpergelenken in der Positioniereinheit können diese als Biege- oder Torsionsgelenke ausgeführt sein.

Der Aktuator ist an den Controller zum Anregen des Generators sowie zur Verarbeitung der von dem Empfänger akustischer Ultraschallwellen erhaltenen Signale angeschlossen.

Die Verwendung eines Aktuators in der Positioniereinheit nicht nur als ein Stellglied, sondern auch als ein Generator oder als Empfänger von akustischen Ultraschallwellen, verleihen der Positioniereinheit qualitativ ganz neue Eigenschaften. So wird ein kostenintensiver Einbau von zusätzlichen diskreten Sendern und Empfängern vermieden. Die Ausfallwahrscheinlichkeit der Positioniereinheit bzw. der Positioniervorrichtung wird aufgrund des Fehlens von zusätzlichen Systemkomponenten erhöht.

Der Resonanzanalysator verarbeitet das von dem Stromsensor kommende Signal, speichert dieses sowie das Signal des Messgenerators und vergleicht bzw. analysiert zwei aufgenommene Resonanzsignale oder Resonanzspektren miteinander. Zum Vergleichen bzw. Analysieren werden effizient zweckmäßige Algorithmen der neuronalen Netze verwendet. Bei Entdeckung von definierten Abweichungen in den analysierten Resonanzbildern wird eine optische oder sonstige Warnung ausgegeben. Die Daten werden außerdem von dem Resonanzanalysator über die optionale Schnittstelle an den Bildschirm eines Computers weitergeleitet. Eine bedienende Person bzw. ein Bediener kann bei Notwendigkeit eine visuelle Analyse oder Kontrolle von Messdaten durchführen.

Eine vorteilhafte Ausführung der erfindungsgemäßen Positioniervorrichtung sieht vor, dass der Messsignalgenerator dazu ausgebildet ist, eine elektrische Sinusspannung mit einem periodischen Frequenzsweep zu erzeugen. Dadurch kann die Positioniereinheit periodisch in einem bestimmten Bereich angeregt werden, so dass ein Resonanzbild in einem definierten Frequenzbereich erzeugt wird, das analysiert werden kann.

Eine weitere vorteilhafte Ausführung der erfindungsgemäßen Positioniervorrichtung sieht vor, dass die Defektanalysevorrichtung einen linearen oder getakteten breitbandigen Ausgangsspannungs- oder Stromverstärker beinhaltet, welcher das von dem Messsignalgenerator erzeugte Signal für die Anregung des Generators in dem notwendigen Frequenzbereich entsprechend verstärkt. Daneben kann es vorteilhaft sein, dass die Defektanalysevorrichtung als Ausgangsspannungs- oder Stromverstärker für den Messsignalgenerator die gleiche Leistungsendstufe benutzt, die der Ansteuerung des Aktuators von dem Steuer-Regelcontroller dient.

Es kann von Vorteil sein, dass die Defektanalysevorrichtung einen Generator für weißes Rauschen umfasst, wobei insbesondere von Vorteil sein kann, dass der Messsignalgenerator zur Erzeugung dieses weißen Rauschens geeignet ist. Das weiße Rauschen beinhaltet ein breites Spektrum an Frequenzen mit einem konstanten Leistungsdichtespektrum in einem definierten Frequenzbereich. Das Signal kann vorteilhaft als eine breitbandige und effiziente Anregung der Positioniereinheit verwendet werden, um deren Resonanzabbild zu erhalten.

Zudem kann es von Vorteil sein, dass der Positionsregler oder der Trajektorien- und Signalgenerator des Controllers mittels eines integrierten Schaltkreises, etwa in Form eines Digital Signal Processors (DSP) oder eines Field Programmable Gate Array (FPGA), realisiert sind, und der Messsignalgenerator und der Resonanzanalysator als ein Programmmodul in demselben integrierten Schaltkreis realisiert sind. Insbesondere bei kostensensitiven Anwendungen ist es von Vorteil, die Funktionen der Defektanalysevorrichtung in demselben integrierten Schaltkreis unterzubringen, der bereits für die Steuerungs- oder Regelungsaufgaben der Positioniereinheit verwendet wird.

Ferner kann es von Vorteil sein, dass der Resonanzanalysator eine Datenschnittstelle zu einem Bildschirm für eine visuelle Kontrolle eines Resonanzbildes aufweist. Die Daten werden dabei von dem Resonanzanalysator über eine Schnittstelle an den Monitor eines Computers weitergeleitet. Ein Bediener kann bei Notwendigkeit eine visuelle Analyse oder Kontrolle von Messdaten durchführen.

Weiterhin kann es von Vorteil sein, dass die Defektanalysevorrichtung zur Erfassung eines von einem Aktuator oder von einem Empfänger erzeugten Signals einen Stromsensor aufweist. Der durch den Aktuator oder durch den Empfänger fließende elektrische Strom beinhaltet die Information über das Resonanzabbild der Positioniereinheit bzw. der Positioniervorrichtung. Der Stromsensor wandelt den von dem Empfänger erzeugten Strom in eine elektrische Spannung U'ᵢ um, verstärkt ihn und stellt ihn dem Resonanzanalysator zur Verfügung. Die Stromumwandlung kann mittels eines Widerstands mit einer nachfolgenden Verstärkung erfolgen oder auch durch einen Transistor, Transformator oder Operationsverstärker. Auch ein Optokoppler kann hierfür vorteilhaft eingesetzt werden. Beim Einsatz eines Optokopplers oder Transformators wird der Aktuator vorteilhaft von dem Defektanalysator galvanisch getrennt.

Außerdem kann es von Vorteil sein, dass mindestens ein Generator oder ein Empfänger zwischen Festkörpergelenken angeordnet ist. Die Anordnung des Generators und des Empfängers von akustischen Ultraschallwellen zwischen Festkörpergelenken wie Biegegelenken, Torsion-Gelenken oder Biegegelenkführungen ermöglicht deren bessere akustische Halterung. Beim Anregen bzw. Empfangen von akustischen Ultraschallwellen wird der Generator sowie der Empfänger seitens umgebender mechanischer Teile weniger belastet. Ihr Schwingen im Ultraschallbereich wird somit weniger beeinträchtigt. Die mechanische Güte dieser mechanischen Schwingkreise wird dadurch größer, und es wird eine geringere Leistung für die Anregung des Generators benötigt. Die Empfindlichkeit des Empfängers wird dadurch ebenfalls größer.

Es kann hierbei von Vorteil sein, dass die Bewegung des Antriebsmittels durch die Festkörpergelenke, zwischen denen der Generator oder der Empfänger angeordnet ist, oder durch zusätzliche Festkörpergelenke der Positioniereinheit geführt ist.

Daneben kann es von Vorteil sein, dass die Ankopplung des Antriebselements an ein zu positionierendes Element über eine feste Verbindung oder über einen Reibkontakt realisiert ist. Eine Positioniereinheit, bei der die Bewegung bzw. Deformation des Aktuators über das Antriebselement auf das zu positionierende Element durch einen Reibkontakt weitergegeben bzw. übertragen wird, ermöglicht eine qualitative Kontrolle des Reibkontaktes der Positioniereinheit. So wird eine Verschlechterung des Reibkontaktes aufgrund einer etwaigen Verunreinigung des Reibpaars direkt mit der akustischen Analyse erfassbar. Gleichfalls ist etwa die Delaminierung einer Reibschiene, mit der das Antriebselement in Friktionskontakt steht bzw. kommt, des zu positionierenden Elements detektierbar. Bei einer festen Verbindung zwischen Antriebselement und zu positionierendem Element kommt es zu einer unmittelbaren Umsetzung der Bewegung des Antriebselements auf das zu positionierende Element, die äußerst präzise und mit hoher Auflösung erfolgen kann, wobei jedoch aufgrund der begrenzten Deformation des Aktuators ein vergleichsweise geringer Stellweg möglich ist.

Darüber hinaus kann es von Vorteil sein, dass ein Generator oder ein Empfänger wenigstens aus einem Teil eines Aktuators gebildet ist. Im Falle eines Multilayeraktuators bildet wenigstens ein Teil der Schichten des Aktuators einen Generator oder einen Empfänger. Durch eine teil- bzw. bereichsweise Beanspruchung bzw. Nutzung des piezoelektrischen Materials für einen Generator oder einen Empfänger kann eine bessere akustische Anpassung von akustischen Ultraschallwellen an die mechanische Umgebung erreicht werden. Im Falle eines Multilayeraktuators kann beispielsweise nur eine Schicht oder etwa die Hälfte aller Schichten für einen Generator oder einen Empfänger verwendet werden. Die Schichten werden hierbei entsprechend elektrisch verbunden und diesbezügliche elektrische Leitungen aus der Positioniereinheit herausgeführt. Die Ansteuerung des Aktuators und des Generators sowie die Übernahme des Signals von dem Empfänger finden in dem Controller statt.

Hierbei kann es sich als günstig erweisen, dass der durch zumindest einen Teil des Aktuators gebildete Generator oder Empfänger keine aktuatorische, d.h. keine eine Deformation bzw. Bewegung hervorrufende Funktion hat, und mit dem restlichen Teil des Aktuators durch eine akustische Verbindung mit einem geringen akustischen Widerstand verbunden ist. Durch die resultierende Trennung des Generators oder Empfängers von akustischen Ultraschallwellen kann eine Struktur realisiert werden, die unabhängig von der aktuatorischen Funktion benutzt werden kann.

Es kann auch von Vorteil sein, dass zur Erfassung von Defekten in der Positioniereinheit ein Generator eines Aktuators und ein Empfänger eines anderen Aktuators benutzt werden. Bei einer Positioniereinheit mit mehreren Aktuatoren kann somit ein Generator akustischer Ultraschallwellen eines Aktuators und ein Empfänger eines anderen Aktuators benutzt werden. Durch die dadurch gegebene räumliche Trennung, d.h. durch Beabstandung, von Generator und Empfänger von akustischen Ultraschallwellen kann die Laufzeitmessung eines akustischen Messsignalimpulses realisiert werden. Die Laufzeitmessung des akustischen Signals stellt eine weitere Methode zum Erfassen von Resonanzen bzw. Defekten in der Positioniereinheit dar.

Die Erfindung betrifft zudem ein Verfahren zum Betreiben der zuvor beschriebenen Positioniervorrichtung zur Vorhersage bzw. Erfassung von entstehenden Defekten in der Positioniervorrichtung bzw. in deren Positioniereinheit. Nach der Erfindung ist vorgesehen: ein Verfahren zum Betreiben der Positioniervorrichtung mit einer Positioniereinheit, die einen piezoelektrischen Aktuator umfasst, einem durch den Aktuator bewegbaren Antriebselement, das zur Kopplung mit einem zu positionierenden Element vorgesehen ist, und einem Controller, wobei die Positioniervorrichtung eine Defektanalysevorrichtung zum Erfassen von Defekten in der Positioniereinheit aufweist, wobei im Falle, dass die Positioniereinheit einen einzigen Aktuator aufweist, dieser einen Generator und einen Empfänger akustischer Ultraschallwellen umfasst, und im Falle, dass die Positioniereinheit mehrere Aktuatoren aufweist, wenigstens einer der Aktuatoren zumindest einen Generator akustischer Ultraschallwellen umfasst und wenigstens ein anderer der Aktuatoren zumindest einen Empfänger akustischer Ultraschallwellen umfasst, und die Defektanalysevorrichtung einen Messsignalgenerator zur Erzeugung eines Messsignals in Form einer elektrischen Wechselspannung zur Anregung des oder eines Generators aufweist, wobei die Defektanalysevorrichtung einen Resonanzanalysator für die Analyse eines von dem oder einem Empfänger erzeugten elektrischen Signals aufweist, wobei ein Generator periodisch mit einem elektrischen Messsignal des Messsignalgenerators in Form einer elektrischen Wechselspannung beaufschlagt wird, und mechanische Resonanzen der Positioniereinheit mit einem Empfänger periodisch aufgenommen werden, und durch den Resonanzanalysator mittels eines Vergleichs von einem Resonanzbild der Positioniereinheit vor dem normalen Betrieb mit einem Resonanzbild der Positioniereinheit während des normalen Betriebs die Entstehung von neuen oder das Verschwinden oder die Veränderung von zuvor existierenden Resonanzen erfasst und analysiert werden zur Vorhersage oder zum Erfassen von Defekten in der Positioniereinheit, wobei der Vergleich des Resonanzbilds vor dem normalen Betrieb mit einem Resonanzbild während des normalen Betriebs nach einer der folgenden Alternativen (A), (B), (C), (D), (E) erfolgt: (A) der Messsignalgenerator erzeugt zur Ermittlung der Resonanzen, die zuvor vorhanden und jetzt verschwunden sind oder sich geändert haben, eine elektrische Sinusspannung, deren Frequenz sich periodisch von einem Anfangs- zu einem Endwert ändert; (B) der Messsignalgenerator erzeugt ein Messsignal, dessen Frequenzwert gleich einem messbaren Resonanzfrequenzwert eines Aktuators ist, wobei die Resonanzfrequenz zu den verschiedenen Arten von akustischen Ultraschallwellen gehört und wobei nach einem kurzen Anregen eines Generators auf der Resonanzfrequenz das Abklingen der Positioniereinheit über einen Empfänger aufgenommen und danach zwecks Erfassung einer Resonanzveränderung die aufgezeichnete Abklingkurve mit einer zu einer früheren Zeit aufgenommenen Abklingkurve verglichen wird; (C) der Messsignalgenerator erzeugt ein Messsignal, dessen Frequenzwert des Messsignals gleich einem messbaren Resonanzfrequenzwert der Positioniereinheit ist, wobei nach einem kurzen Anregen eines Generators das Abklingverhalten der Positioniereinheit zwecks Erfassung einer Resonanzveränderung aufgezeichnet und mit einem zu einer früheren Zeit aufgenommenen Abklingverhalten verglichen wird; (D) der Messsignalgenerator erzeugt ein Messsignal, dessen Frequenzwert des Messsignals gleich mindestens einem messbaren Resonanzfrequenzwert der Positioniereinheit ist, wobei während des Anregens eines Generators zwecks Erfassung mindestens einer Resonanzveränderung der innere Widerstand Rᵢ=U_{A}/I_{A} der Positioniereinheit bestimmt und mit einem zu einer früheren Zeit aufgenommenen Wert des inneren Widerstands der Positioniereinheit verglichen wird; (E) der Messsignalgenerator erzeugt ein Messsignal, dessen Frequenzwert des Messsignals im Wesentlichen gleich einem messbaren Resonanzfrequenzwert der Positioniereinheit ist, und dabei während oder nach einem kurzen Anregen eines Generators der reflektierte Impuls von einem Empfänger aufgenommen wird, wobei Parameter des reflektierten Impulses zwecks Erfassung einer Resonanzveränderung aufgezeichnet und mit zu einer früheren Zeit aufgenommenen Parametern verglichen werden.

Jede Komponente der Positioniereinheit stellt einen mechanischen Oszillator dar, der eine durch seine Abmessungen, Materialeigenschaften sowie die Einbauweise bestimmte Resonanzen aufweist. Risse in Komponenten der Positioniereinheit, Delaminierungen in der mehrschichtigen Struktur eines Multilayeraktuators, Materialermüdung in Festkörpergelenken sowie andere Defekte der Positioniereinheit führen zur Veränderung ihres akustischen Abbildes. Es entstehen neue Resonanzen, bereits existierende Resonanzen verändern sich oder verschwinden sogar.

Das erfindungsgemäße Verfahren sieht vor, dass der Aktuator außer zur Funktion eines Stellgliedes, d.h. zur Erzeugung einer der Positionierung eines zu positionierenden Elements dienenden Bewegung des Antriebselements aufgrund einer Deformation des Aktuators, ebenfalls zur Funktion eines Generators oder eines Empfängers von akustischen Ultraschallwellen genutzt bzw. betrieben wird, wobei diese akustischen Ultraschallwellen zum Erfassen von Defekten in der Positioniereinheit verwendet werden.

Dazu wird der bzw. ein Aktuator periodisch mit einem elektrischen Messsignal des Messsignalgenerators der Defektanalysevorrichtung beaufschlagt. Das Messsignal kann eine elektrische Wechselspannung oder ein Wechselstrom sein. Der Aktuator bzw. der Generator regt in der gesamten Positioniereinheit akustische Ultraschallwellen an, die als mechanische Resonanzen der gesamten Positioniereinheit sowie des Aktuators selbst durch den Aktuator bzw. Empfänger periodisch aufgenommen und dem Resonanzanalysator zur Verarbeitung zu Verfügung gestellt werden. Der Resonanzanalysator verarbeitet das von einem optionalen Stromsensor kommende Signal und speichert dieses sowie das Signal des Messsignalgenerators.

In einem weiteren Schritt vergleicht bzw. analysiert der Resonanzanalysator zwei aufgenommene Signale oder Resonanzspektren der Positioniereinheit miteinander. Bei diesem Vergleich werden die zuvor vorhandenen und jetzt verschwundenen oder sich verändernden Resonanzen erfasst, sowie neu entstandene Resonanzen registriert. Zum Vergleichen bzw. Analysieren werden zweckmäßige effiziente Algorithmen der neuronalen Netze verwendet. Bei Entdecken definierter Abweichungen in den analysierten Resonanzbildern wird eine optische oder sonstige Warnung ausgegeben.

Das erfindungsgemäße Verfahren zur Vorhersage und zum Erfassen von Defekten in der erfindungsgemäßen Positioniereinheit sowie deren Komponenten ermöglicht ein automatisches Beobachten des Zustands der Positioniereinheit und einen rechtzeitigen Austausch bzw. eine rechtzeitige Wartung beim Auftreten von Defekten. Die Verwendung eines piezoelektrischen Aktuators in der Positioniereinheit nicht nur als ein Stellglied, sondern auch als ein Generator oder Empfänger von akustischen Ultraschallwellen verleihen der Positioniereinheit qualitativ ganz neue Eigenschaften. Die erfindungsgemäße Positioniervorrichtung bzw. das entsprechende erfindungsgemäße Verfahren erspart insbesondere einen kostenintensiven Einbau von zusätzlichen diskreten Sendern und Empfängern.

Bei dem Verfahren wird der bzw. ein Aktuator entweder von einer Leistungsendstufe mit einer elektrischen Gleichspannung oder von einer niederfrequenten elektrischen Wechselspannung beaufschlagt, oder aber von einem Verstärker mit einer hochfrequenten elektrischen Wechselspannung. Als niederfrequent wird hierbei eine Spannung bezeichnet, deren Frequenz mindestens dreimal niedriger ist als die Frequenz der niedrigsten Resonanz der Positioniereinheit. Als hochfrequent ist hierunter zu verstehen, dass die Frequenz der Spannung nahezu gleich der niedrigsten Resonanzfrequenz der Positioniereinheit oder höher ist. Die Umschaltung findet durch einen optionalen Kommutator statt. Beim Beaufschlagen des piezoelektrischen Materials des Aktuators mit einer elektrischen Spannung erfährt dieser je nach dem Spannungsvorzeichen eine Ausdehnung oder eine Kontraktion, und vollführt dabei eine Stellfunktion, d.h. er überträgt diese Ausdehnung oder Kontraktion auf das mit ihm verbundene Antriebsmittel, das seinerseits zur Kopplung mit einem zu positionierenden Element vorgesehen ist, und über diese Kopplung kann eine Stellbewegung des zu positionierenden Elements erzielt werden.

Außer der Stellgliedfunktion hat der Aktuator bzw. ein Teil davon die Funktion eines Generators oder eines Empfängers von akustischen Ultraschallwellen. Bei der Beaufschlagung eines Generators mit einem Messsignal von einem Verstärker werden in dessen Umgebung bzw. in der Positioniereinheit akustische Ultraschallwellen angeregt und von einem Empfänger empfangen und in einen elektrischen Strom umgewandelt. Der durch den Aktuator fließende Strom I_{A}, gelangt zu dem optionalen Stromsensor, wird durch diesen in eine elektrische Spannung Uᵢ umgeformt und weiter von dem Resonanzanalysator verarbeitet.

Es kann von Vorteil sein, dass das Erkennen der neu entstandenen oder das Verschwinden oder die Veränderung der zuvor existierenden Resonanzen durch das Bilden des Betrags der elektrischen Impedanz |Z| der Positioniereinheit in Abhängigkeit von der Frequenz durchgeführt wird. Dazu wird die Frequenz der Messsignalspannung U_{MG} gemäß einem Frequenzsweep von einem Anfangswert f_{A} zu einem Endwert f_{E} verändert, und der durch den Empfänger fließende Stromwert I_{A}, sowie der Phasenwinkelwert *φ* zwischen dem Strom und der Spannung U_{A}, in Abhängigkeit von der Frequenz gemessen und zusammen mit der Spannung aufgezeichnet. Aus den Messreihen wird zur Erkennung von Resonanzen der Verlauf des Impedanzbetrags |Z|= U_{A}/I_{A} in Abhängigkeit der Frequenz gebildet. Danach wird aus dem Impedanzverlauf Z (|Z|=f(f)) und dem Verlauf *φ*(f) von dem Resonanzanalysator das Vorhandensein von neuen oder das Fehlen von zuvor existierenden mechanischen Resonanzen bestimmt.

Im Verlauf der Impedanz sind alle Resonanzen der Positioniereinheit enthalten. Das Auftreten von Defekten in Systemkomponenten der Positioniereinheit verursacht ein Entstehen von neuen Resonanzen in der Positioniereinheit bzw. ein Verändern des zuvor existierenden Resonanzbilds. Diese Veränderungen sind in dem Impedanzverlauf leicht erkennbar. Sie lassen sich im Resonanzanalysator vorteilhaft unter Verwendung von Algorithmen der neuronalen Netze der Mustererkennung identifizieren.

Es kann auch von Vorteil sein, dass bei dem Frequenzsweep der durch den Empfänger fließende Stromwert sowie der Phasenwinkelwert zwischen dem Strom und der Spannung in Form einer Abhängigkeit von der Frequenz gemessen und zusammen mit der Spannung aufgezeichnet wird, wobei aus den Messreihen zur Erkennung von Resonanzen der Impedanzbetrag |Z| sowie der Phasenwinkel φ in einem Nyquist-Diagramm dargestellt werden. Das Nyquist-Diagramm erlaubt ein besonders vorteilhaftes Darstellen des Frequenzbildes der Positioniereinheit aufgrund einer gleichzeitigen Darstellung des Betrags der Impedanz mit dem Phasenwinkel.

Zudem kann es von Vorteil sein, dass bei dem Frequenzsweep der Frequenzanfangswert des Messsignals gleich oder etwas kleiner als der niedrigste messbare Resonanzfrequenzwert eines Aktuators ist, und der Resonanzfrequenzendwert des Messsignals gleich oder etwas größer als der Resonanzfrequenzwert der höchsten messbaren Resonanz eines Aktuators ist, wobei sowohl der niedrigste Resonanzfrequenzwert als auch der höchste Resonanzfrequenzwert zu den unterschiedlichen Arten von akustischen Ultraschallwellen, beispielsweise den Longitudinal-, Biege, Radial-, Scher- oder anderen Schwingungsmoden des Aktuators, gehören können.

Der vorzugsweise mehrschichtige piezoelektrische Aktuator ist eine wesentliche Komponente der Positioniereinheit der Positioniervorrichtung. Der Aktuator besitzt spezifische Eigenmoden sowie dazugehörige Eigenresonanzen. Die Eigenresonanzen des Aktuators lassen sich vor dem Einbau in die Positioniereinheit identifizieren. Nach dem Einbau sind sie bei Anregung in dem Resonanzbild der Positioniereinheit enthalten und ebenfalls erkennbar. Durch die Anregung der Positioniereinheit in dem Frequenzbereich der Resonanzfrequenzen eines Aktuators werden gezielt Defekte in diesem Aktuator erfasst.

Ferner kann es bei dem Frequenzsweep von Vorteil sein, dass der Frequenzanfangswert des Messsignals gleich dem niedrigsten Resonanzfrequenzwert eines Aktuators ist, der durch dessen Länge bestimmt wird, und der Frequenzendwert des Messsignals gleich dem doppelten Resonanzfrequenzwert, der durch die Hälfte der Aktuatorlänge bestimmt wird, beträgt.

Der Aktuator wird im Betrieb gewöhnlich besonders stark durch eine longitudinale Ausdehnung beansprucht. Durch diese Beanspruchungsart entstehen oft Risse zwischen den einzelnen Schichten sowie Delaminierungen im Falle der Verwendung eines Multilayeraktuators. Durch Anregen sowie Resonanzanalyse der Positioniereinheit im Frequenzbereich der Longitudinal- sowie Biegeschwingungsmoden des Aktuators können diese Art von Defekten gezielt erfasst werden.

Außerdem kann es bei dem Frequenzsweep von Vorteil sein, dass die Frequenz der elektrischen Messspannung vom Anfangs- bis zum Endwert logarithmisch oder nach einer anderen zweckmäßigen Funktion verändert wird. Dies ermöglicht es, einen schnellen Defekttest der Positioniereinheit durchzuführen oder das Erfassen der Resonanzen einer Positioniereinheit mit einem bestimmten akustischen Bild anzupassen.

Darüber hinaus kann es von Vorteil sein, dass das Messsignal ein weißes Rauschen ist und der durch den Aktuator fließende Strom gemessen und aufgezeichnet wird. Danach wird die Messreihe zwecks Erkennung von Resonanzen einer Fouriertransformation, einer diskreten Fouriertransformation (DFT) oder einer schnellen Fouriertransformation (FFT) unterzogen. Dabei werden neu entstandene, verschwundene oder veränderte Resonanzen erfasst. Fourier-Transformationen lassen sich effizient in einem DSP oder einem FPGA realisieren und ermöglichen eine schnelle Analysedurchführung. Bei dem Ergebnis einer Fouriertransformation werden Resonanzen als Amplituden leicht erkennbar dargestellt, so dass das Erkennen von Veränderung in dem Resonanzabbild der Positioniereinheit ebenfalls effizient durchgeführt werden kann.

Des Weiteren kann es von Vorteil sein, dass der Frequenzwert des Messsignals gleich einem messbaren Resonanzfrequenzwert des Aktuators ist, wobei die Resonanz zu den verschiedenen Arten von akustischen Ultraschallwellen, beispielsweise den Longitudinal, Biege, Radial-, Scher- oder anderen Schwingungsmoden des Aktuators, gehören kann, und nach einem kurzen Anregen eines Generators auf dieser Resonanzfrequenz das Abklingen der Positioniereinheit mittels eines Empfängers aufgenommen wird, und weiter zwecks Erfassung einer Resonanzveränderung die aufgezeichnete Abklingkurve mit der zu einer früheren Zeit aufgenommenen Abklingkurve verglichen wird.

Der elektrische Strom einer durch einen piezoelektrischen Aktuator angetriebenen Positioniereinheit klingt nach dem Anstoßen bzw. Anregen des Aktuators auf einer Resonanz annährend gemäß der Funktion I=I₀EXP(-λt)sin(ωt) ab, wobei I der Strom, I₀ der Anfangsstrom, λ die Abklingkonstante, ω die Kreisfrequenz und t die Zeit ist. Bei Veränderung einer der Resonanzen infolge eines Defektes lässt sich diese Veränderung durch das Abklingverhalten bzw. in der Veränderung der Amplitudenabklingfunktion Aᵢ=I₀EXP(-λt), der Abklingzeit oder der Frequenz der abklingenden Schwingung erkennen. Die Abklingzeit sowie Abklingfunktion der Schwingung lassen sich durch eine auf einem Mikroprozessor basierten Messvorrichtung schnell und einfach aufnehmen. Die im Aktuator entstehenden Defekte können durch Vergleichen von Abklingkurven erkannt werden.

Es kann vorteilhaft sein, dass der Frequenzwert des Messsignals gleich einem messbaren Resonanzfrequenzwert der Positioniereinheit ist, wobei nach einem kurzen Anregen eines Generators das Abklingverhalten der Positioniereinheit zwecks Erfassung einer Resonanzveränderung aufgezeichnet und mit einem zu einer früheren Zeit aufgenommenen Abklingverhalten verglichen wird. Durch Beobachtung des Veränderns spezifischer Resonanzen der Positioniereinheit lassen sich Defekte in deren Komponenten bzw. Konstruktionsteilen erfassen.

Es kann auch vorteilhaft sein, dass der Frequenzwert des Messsignals gleich einem messbaren Resonanzfrequenzwert der Positioniereinheit ist, wobei während des Anregens eines Generators zwecks Erfassung einer Resonanzveränderung der innere Widerstand Rᵢ=U_{A}/I_{Ar} der Positioniereinheit bestimmt und mit einem zu einer früheren Zeit aufgenommenen inneren Widerstand verglichen wird.

Beim Entstehen von Defekten in der Positioniereinheit werden einige zuvor vorhandene Resonanzen verändert. Die Resonanzkurve eines mechanischen Oszillators ist durch seinen Verlustwiderstand Rᵥ, hier als der innere Widerstand Rᵢ bezeichnet, charakterisiert. Jede Resonanz der Positioniereinheit stellt ein Oszillator dar, der einen inneren Widerstand Rᵢ aufweist. Ri wird durch entstehende Defekte verändert. Der innere Widerstand Rᵢ kann durch die Aufnahme der elektrischen Spannung am Aktuator U_{Ar} sowie des Stroms durch den Aktuator I_{Ar} bei einer definierten Resonanzfrequenz fᵣ bestimmt werden. Die Aufnahme der Spannung U_{Ar} und des Stroms I_{Ar} lassen sich von einer auf einem Mikrocontroller basierten Messvorrichtung einfach realisieren und schnell analysieren.

Es kann zudem vorteilhaft sein, dass der Frequenzwert des Messsignals gleich einem messbaren Resonanzfrequenzwert der Positioniereinheit ist, wobei während oder nach dem Anregen eines Generators zwecks Erfassung einer Resonanzveränderung der reflektierte Impuls von einem Empfänger aufgenommen wird und seine Parameter mit denen eines früher aufgenommenen reflektierten Impulses verglichen werden.

Zum Detektieren von Defekten kann dabei die Laufzeit, die Amplitude oder die Form des reflektierten Impulses verwendet werden. Der Ultraschallimpuls kann durch einen Generator eines Aktuators gesendet und von einem Empfänger eines anderen Aktuators empfangen werden. Das Erfassen der Resonanzveränderung der Positioniereinheit durch das Anregen eines kurzen Impulses und die Auswertung von Parametern eines reflektierten Impulses ermöglicht eine schnelle Defektidentifizierung der Positioniereinheit. Dabei kann das Messignal mehrere Impulse beinhalten. Die Impulse können außerdem amplituden- oder phasenmoduliert sein.

Es kann außerdem vorteilhaft sein, dass die Erfassung von Resonanzen und die Defektanalyse im normalen Betriebsmodus der Positioniereinheit durchgeführt werden. Das Resonanzbild der Positioniereinheit wird hierbei einmal während der ersten Inbetriebnahme aufgenommen und dann weiter periodisch bzw. wiederholt während des normalen Betriebs. Die Messaufnahmen werden mit der ersten Aufnahme verglichen und analysiert. Dadurch kann man - ohne den Betrieb der Positioniereinheit zu unterbrechen - deren Zustand beobachten.

Darüber hinaus kann es vorteilhaft sein, dass die Analyse des aufgenommenen Resonanzbildes visuell von einem Bediener durchgeführt werden kann. Dadurch ist es möglich, bei nichteindeutigen Resonanzbildern ein Eingreifen durch eine Person zu ermöglichen bzw. ein Austausch der defekten Positioniereinheit oder defekter Komponenten dieser einzuleiten. Zu diesem Zweck kann die erfindungsgemäße Vorrichtung einen Computer mit einem Bildschirm bzw. Monitor beinhalten.

Weitere Einzelheiten, Vorteile und Merkmale der Erfindung ergeben sich aus der folgenden Beschreibung und den Zeichnungen, auf die bezüglich aller nicht im Text beschriebenen Einzelheiten ausdrücklich verwiesen wird. Es zeigen;
Fig.1: Schematische Darstellung einer erfindungsgemäßen Positioniervorrichtung
Fig.2: Schematische Darstellung einer Ausführungsform eines piezoelektrischen mehrschichtigen Aktuators einer Positioniereinheit mit einem Generator und einem Empfänger von akustischen Ultraschallwellen
Fig.3: a) Spannung des Messignalgenerators U_{MG} mit einer veränderlichen Frequenz; b) FEM-Modell eines mehrschichtigen Aktuators mit einer Delaminierung der Schichtstruktur, angeregt durch das Messignal gemäß Fig. 3a)-3c) Beispielhafter Verlauf der elektrischen Impedanz eines intakten Aktuators als Funktion der Frequenz f, angeregt durch das Messignal gemäß Fig. 3a); d) Beispielhafter Verlauf der elektrischen Impedanz eines Aktuators mit Delaminierung als Funktion der Frequenz f, angeregt durch das Messignal gemäß Fig. 3a)
Fig.4: a) FEM-Modell der erfindungsgemäßen Positioniereinheit mit einem Aktuator, der eine Delaminierung der Schichtstruktur aufweist, angeregt durch das Messignal gemäß Fig. 3a); b) beispielhafter Verlauf des Betrags der elektrischen Impedanz |Z| der Positioniereinheit als Funktion der Frequenz mit einem intakten und einem Riss aufweisenden Aktuator als Funktion von f, angeregt durch das Messignal gemäß Fig. 3a)
Fig.5: a) Signal des weißen Rauschens; b) Amplitudenspektrum der Positioniereinheit, angeregt von einem Messsignalgenerator mit dem Signal des weißes Rauschens gemäß Fig. 5a)
Fig.6: Beispielhafte Stromabklingkurven der Positioniereinheit mit einem intakten und einem delaminierten Aktuator
Fig. 7: Stromresonanzkurve der Positioniereinheit zur Erläuterung der Messung des Verlustwiderstandes
Fig. 8a)-8c): Unterschiedliche Formen von Ultraschallimpulsen; d) Echo von Ultraschallimpulsen
Fig. 9: Prinzipaufbau einer möglichen schaltungstechnischen Realisierung eines gleichzeitigen Normalbetriebs eines Aktuators einer Positioniereinheit einer erfindungsgemäßen Positioniervorrichtung mit dem Resonanzanalysemodus, wobei 9a) den Anschluss einer Leistungsendstufe sowie eines Strom- oder Spannungsverstärkers an den Aktuator über eine Induktivität bzw. über eine Kapazität verdeutlicht, während 9b) den Anschluss einer Leistungsendstufe an den Aktuator über einen Transformator zeigt
Fig. 10: Positioniervorrichtung mit gemeinsamer Leistungsstufe sowie einer gleichzeitigen Anordnung des Messsignalgenerators, des Resonanzanalysators sowie des Steuer-Regelcontrollers in demselben integrierten Schaltkreis
Fig. 11a)-11e): Prinzipaufbau eines Stromsensors in unterschiedlichen Ausführungen
Fig. 12: Schematische Darstellung einer Positioniereinheit mit mehreren mehrschichtigen Aktuatoren, bei der die Kopplung zwischen dem Antriebselement und dem zu positionierenden Element über einen Reibkontakt realisiert ist
Fig. 13: Aktuator mit bereichsweiser Ausnutzung der Schichten zur Realisierung eines Generators und eines Empfängers
Fig. 14: Beispielhafte Realisierung eines Generators oder eines Empfängers als ein mit dem Aktuator verbundenes, jedoch nicht aktuatorisch wirkendes Teil

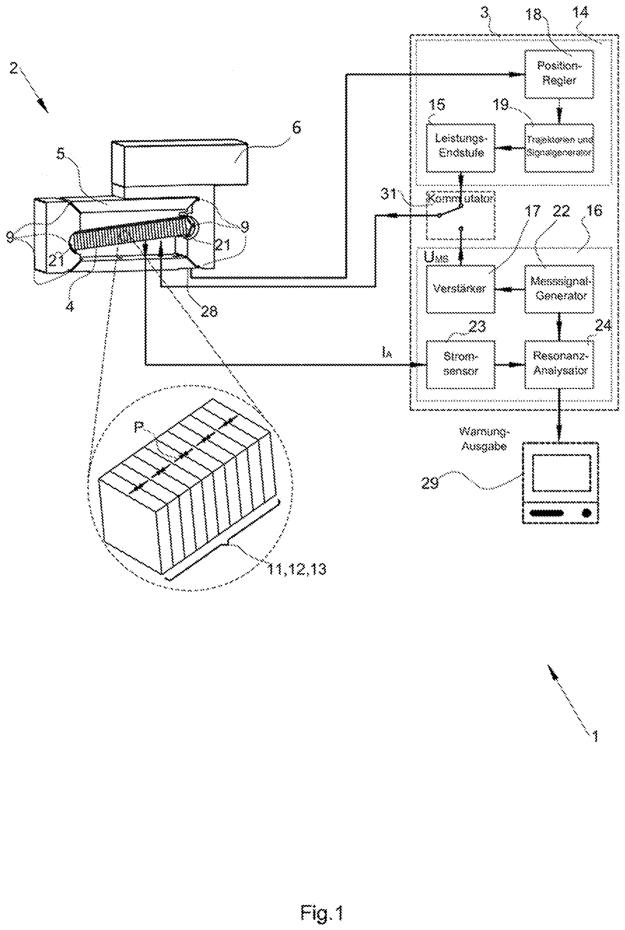

Fig. 1 illustriert schematisch eine erfindungsgemäße Positioniervorrichtung 1 zum Erfassen von Defekten in einer durch einen Aktuator 4 angetriebenen Positioniereinheit 2.

Die Positioniervorrichtung 1 umfasst neben der Positioniereinheit 2 den Controller 3. Die Positioniereinheit 2 umfasst neben einem einzelnen piezoelektrischen und mehrschichtigen Aktuator 4, welcher dazu ausgebildet ist, neben seiner Bewegungs- bzw. Antriebsfunktion noch die Funktion eines Generators 12 und eines Empfängers 13 akustischer Ultraschallwellen aufzuweisen, ein durch den Aktuator 4 bewegtes bzw. angetriebenes Antriebselement 5, das mit einem zu positionierenden Element 6 durch eine feste Verbindung gekoppelt ist. Zudem beinhaltet die Positioniereinheit 2 einen in Fig. 1 nicht dargestellten Positionssensor.

Der Aktuator 4 stützt sich an seinen beiden Enden an Halteelementen 21 ab, die über Festkörpergelenke 9 mit einem den Aktuator umgebenden Rahmen verbunden sind, so dass das in den Rahmen integrierte Antriebselement 5 über die Festkörpergelenke 9 mit dem Aktuator 4 gekoppelt ist und Bewegungen bzw. Deformationen des Aktuators 4 auf das Antriebselement 5 übertragbar sind.

Der piezoelektrische Aktuator 4 ist aus mehreren Schichten 11 aufgebaut, wobei jede Schicht aus zwei Elektroden und einem dazwischen angeordneten polarisierten piezoelektrischen Werkstoff besteht. Mögliche Polarisationsrichtungen der einzelnen Schichten sind in Fig. 1 mit den Pfeilen P gekennzeichnet.

Der Controller 3, welcher die Funktion hat, den Aktuator 4 bzw. die Positioniereinheit 2 zu steuern oder zu regeln, den Generator 12 mit einem Messsignal anzuregen, sowie das von dem Empfänger 13 kommende Signal zu verarbeiten, umfasst einen Steuer-Regelcontroller 14, eine Defektanalysevorrichtung 16, von der der Generator 12 angeregt und das Signal des Empfängers 13 aufgezeichnet und analysiert wird, sowie optional einen Kommutator 31. In dem Kommutator 31 findet ein Umschalten zwischen einem aktuatorischen Betrieb des Aktuators 4 und einem sensorischen Betrieb, bei dem der Aktuator oder ein Teil davon als Generator 12 bzw. als Empfänger 13 fungiert, statt. Außerdem kann der Controller 3 eine Schnittstelle zu einem Computer 29 mit einem Bildschirm aufweisen, an dem die Defektanalyse visuell durch eine bedienende Person vorgenommen werden kann.

Der Steuer-Regelcontroller 14 beinhaltet eine Leistungsendstufe 15 für den Aktuator 4, einen Trajektorien- und Signalgenerator 19, einen Regler 18 für die Position sowie optional für die Geschwindigkeit und Beschleunigung der Positioniereinheit 2.

Die Defektanalysevorrichtung 16 umfasst einen Strom-Spannungsverstärker 17 für den Generator 12, einen Messsignalgenerator 22, einen Stromsensor 23 für den von dem Empfänger 13 erzeugten Signal, sowie einen Resonanzanalysator 24.

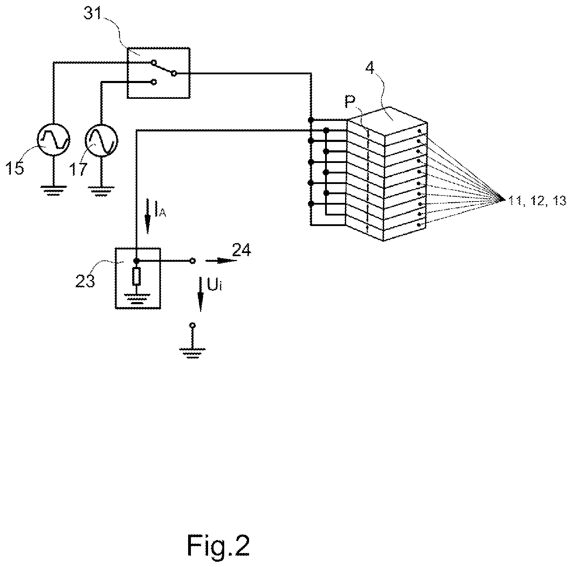

Fig. 2 veranschaulicht eine schematische Darstellung einer bevorzugten Ausführungsvariante des piezoelektrischen Aktuators 4 mit einem Generator 12 und einem Empfänger 13. Die Schichten 11 des Aktuators 4 sind durch leitende metallisierte Flächen sowie einem zwischen ihnen befindlichen polarisierten piezoelektrischen Material gebildet. Bei einer möglichen Variante der elektrischen Polarisation der Schichten 11 sind Polarisationsvektoren der benachbarten Schichten entgegengesetzt zueinander gerichtet. Der Vektor der elektrischen Polarisation ist in Fig. 2 sowie in den entsprechenden anderen Figuren mit einem Pfeil P gekennzeichnet. Die Schichten 11 sind elektrisch parallel und mechanisch in Reihe geschaltet.

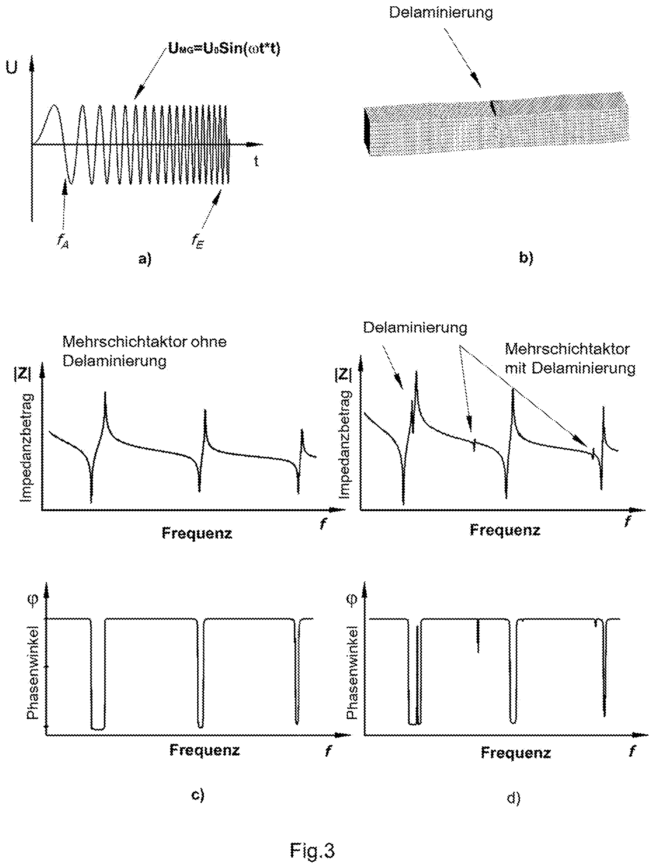

Fig. 3a) veranschaulicht die Spannung U_{MG} des Messignalgenerators mit einer veränderlichen Frequenz, während Fig. 3b) das FEM-Modell eines mehrschichtigen Aktuators 4 mit einer Delaminierung der Schichtstruktur veranschaulicht. Fig. 3c) verdeutlicht einen beispielhaften Verlauf der elektrischen Impedanz eines intakten Aktuators als Funktion der Frequenz f. Hierbei sind Resonanzen von drei Schwingungsmoden des Aktuators 4 zu sehen, nämlich die erste, die dritte und die fünfte Longitudinalmode. Fig. 3d) veranschaulicht einen beispielhaften Verlauf der elektrischen Impedanz des Aktuators 4 mit einer Delaminierung als Funktion der Frequenz f. Hierbei sind zusätzliche Resonanzen zu sehen, die aufgrund der Delaminierung entstanden sind.

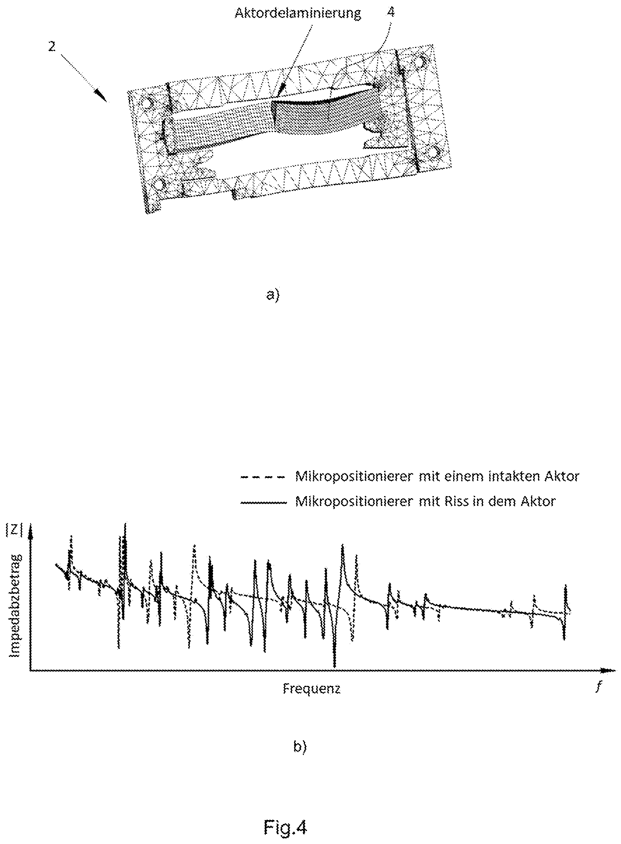

Fig. 4a) zeigt das FEM-Model einer Positioniereinheit 2 mit einem Aktuator 4 gemäß Fig. 1, der eine Delaminierung der Schichtstruktur aufweist. Fig. 4b) veranschaulicht einen beispielhaften Verlauf des Betrags der elektrischen Impedanz einer Positioniereinheit 2 als Funktion der Frequenz mit einem intakten und einem gerissenem Aktuator 4 als Funktion von f. Aufgrund der Delaminierung in dem Aktuators 4 unterscheiden sich die Verläufe des Impedanzbetrags wesentlich. Es sind Resonanzen verschwunden, die bei intaktem Aktuator vorhanden waren, und neue Resonanzen aufgrund der Delaminierung sind hinzugekommen.

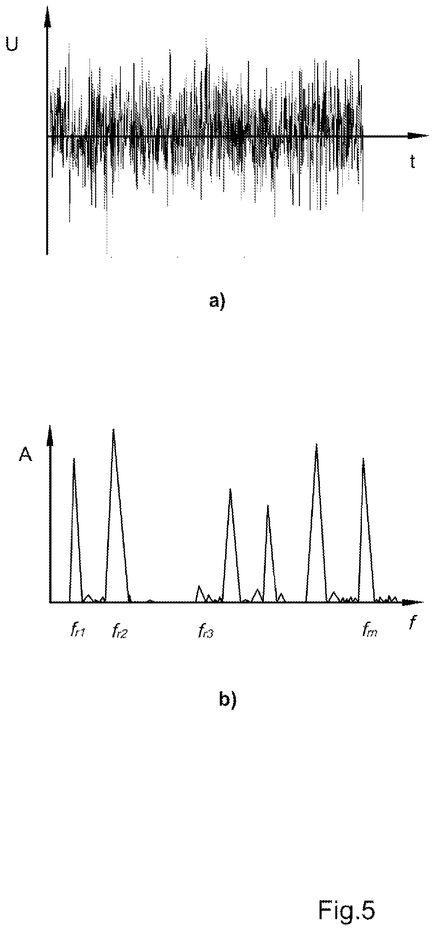

Fig. 5a) veranschaulicht das Amplitudenspektrum der durch weißes Rauschen angeregten Positioniereinheit, während Fig. 5b) dem einer Fouriertransformation unterzogenen und als Funktion der Frequenz aufgezeichneten durch den Aktuator 4 bzw. den Empfänger 13 fließenden Strom entspricht.

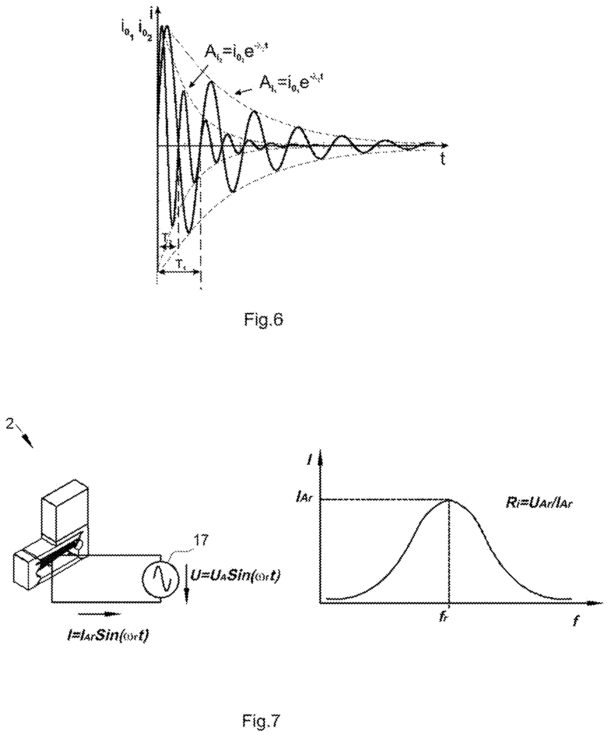

Fig. 6 veranschaulicht beispielhaft Stromabklingkurven einer Positioniereinheit 2 mit einem intakten und einem delaminierten Aktuator. Der Aktuator wurde hier bei einer seinen Resonanzfrequenzen angeregt. Die Abklingkurve der Positioniereinheit mit einem beschädigten Aktuator mit der Amplitudenabklingfunktion Aᵢ₂ klingt aufgrund der veränderten Resonanzfrequenz sowie der Abklingkonstante λ₂ schneller ab als die Aᵢ₁ mit dem intakten Aktuator. Aufgrund der Delaminierung hat sich bei der Amplitudenabklingfunktion Aᵢ₂ die Schwingperiode T2 verringert.

Fig. 7 veranschaulicht eine Stromresonanzkurve einer Positioniereinheit 2 gemäß Fig. 1. Diese wird in einer ihrer Resonanzen durch ein Sinus-Messsignal der Amplitude U_{Ar} angeregt. Der durch den Empfänger 13 fließende Strom I_{Ar} wird gemessen. Rᵢ=U_{Ar}/I_{Ar} wird durch die Defektanalysvorrichtung bestimmt und mit einem früher gemessenen Wert verglichen. Beim Eintreten einer definierten Abweichung wird eine Warnung ausgegeben.

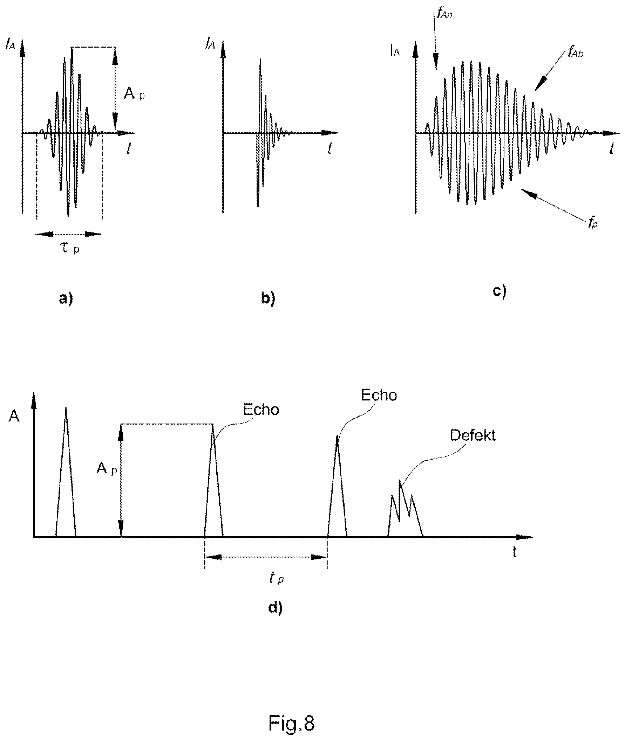

Fig. 8 veranschaulicht unterschiedliche Formen der von einem Generator 12 ausgesendeten Ultraschallimpulse sowie der von der Positioniereinheit 2 reflektierten und von dem Empfänger 13 erfassbaren Ultraschallimpulse. Die Ultraschallimpulse können gemäß Fig. 8a) einen exponentiellen Anstieg sowie ein exponentielles Abklingen aufweisen, gemäß Fig. 8b) nur ein exponentielles Abklingen aufweisen, oder gemäß Fig. 8c) auch unterschiedlichen Anstiegs- sowie Abklingfunktionen aufweisen. Die Ultraschallimpulse werden durch ihre Amplitude Aₚ, die Frequenz fₚ, die Dauer τ, die Anstieg- und Abklingfunktionen f_{An}, f_{Ap} sowie die Laufzeit tₚ charakterisiert.

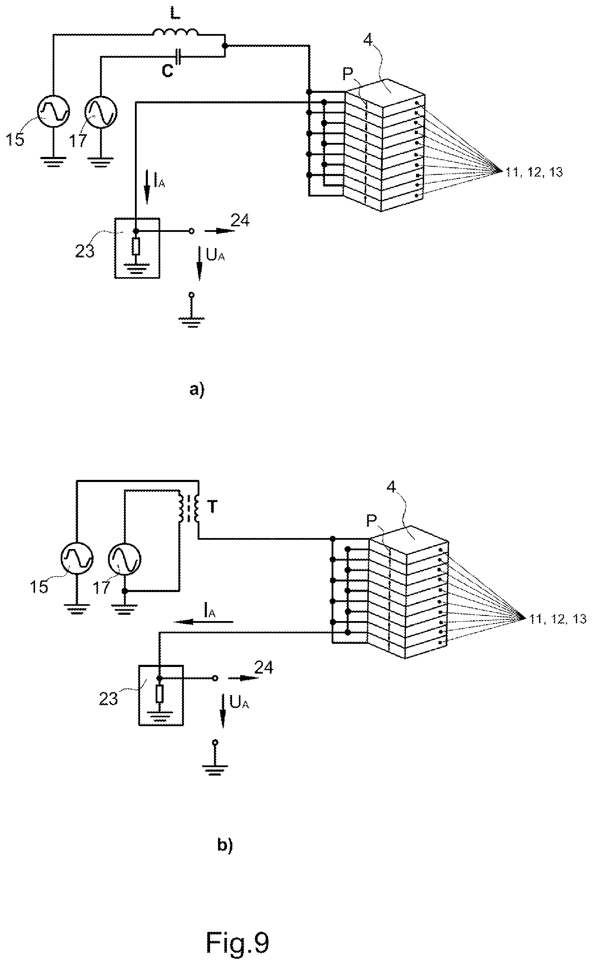

Fig. 9 veranschaulicht den Prinzipaufbau einer möglichen schaltungstechnischen Realisierung für einen gleichzeitigen Normalbetrieb der Positioniervorrichtung bzw. der Positioniereinheit mit einem Resonanzanalysemodus. Gemäß Fig. 9a) ist die Leistungsendstufe 15 über eine Induktivität L an den Aktuator 4 angeschlossen. Der Strom- oder Spannungsverstärker 17 regt den Aktuator 4 bzw. den Generator 12 über eine Kapazität C an. Durch die Kapazität C wird einerseits die Leistungsendstufe 15 gleichstrommäßig von dem Verstärker 17 getrennt. Andererseits trennt die Induktivität L den Verstärker 17 wechselstrommäßig von der Leistungsendstufe 15. Nach Fig. 9b) ist die Leistungsendstufe 15 über die Sekundärwicklung des Transformators T an den Aktuator 4 angeschlossen. Der Strom- oder Spannungsverstärker 17 regt den Generator 12 über die Primärwicklung des Transformators T an. Durch den Transformator T wird die Leistungsendstufe 15 gleichstrommäßig von dem Verstärker 17 getrennt.

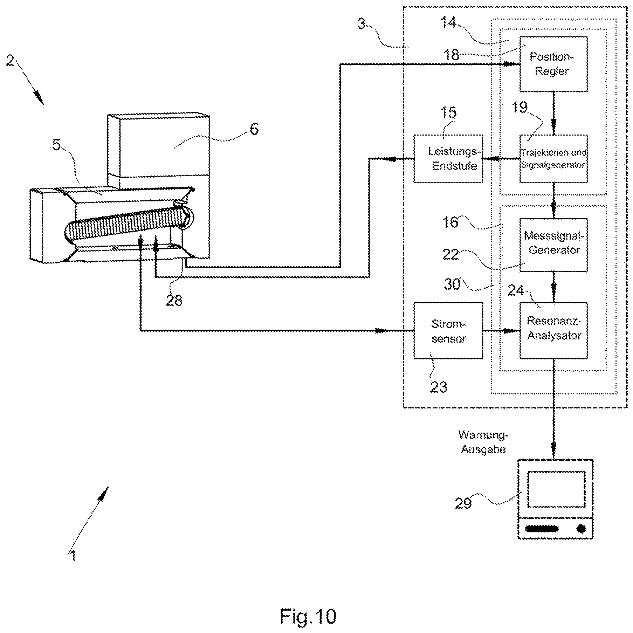

Fig. 10 veranschaulicht eine Positioniervorrichtung 1 mit einer Positioniereinheit 2 gemäß Fig. 1, bei der von der Defektanalysevorrichtung als Ausgangsspannungs- oder- Stromverstärker für den Messsignalgenerator 22 die gleiche Leistungsendstufe 15 benutzt wird, die zur Ansteuerung des mehrschichtigen Aktuators von dem Steuer-Regelcontroller verwendet wird. In diesem Fall weist die Leistungsendstufe 15 eine ausreichende Bandbreite auf, die den Anforderungen zum Erzeugen von akustischen Ultraschallwellen durch den Aktuator bzw. Generator 12 genügt. Dadurch spart man die Kosten und Platz für den Einbau eines separaten Verstärkers.

Fig. 10 verdeutlicht weiterhin eine Ausführungsform der Positioniervorrichtung 1, bei welcher der Messsignalgenerator 22 sowie der Resonanzanalysator 24 in demselben integrierten Schaltkreis 30 untergebracht sind wie der Steuer-Regelcontroller 14.

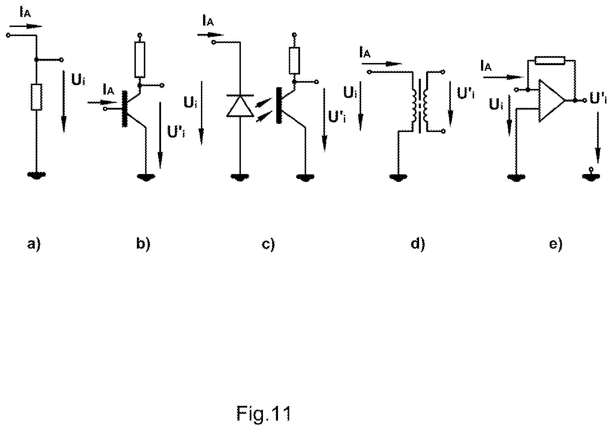

Fig. 11 veranschaulicht den Prinzipaufbau möglicher Schaltungen für die erste Verarbeitung des von dem Empfänger 13 kommenden elektrischen Signals in Form eines Stroms oder einer Spannung. Entsprechend Fig.11a) kann der von dem Empfänger 13 kommende Strom I_{A}, mit Hilfe eines Widerstands durch die Spannung Uᵢ abgebildet werden. Durch die Schaltung in der der Fig.11b) wird der von dem Empfänger 13 kommende Strom I_{A} mit Hilfe eines Transistors in eine Spannung U'ᵢ überführt. In Fig.11c) wird der von dem Empfänger 13 kommende Strom I_{A}, mit Hilfe eines Optokopplers in eine Spannung U'ᵢ abgebildet. In der in Fig.11d) dargestellten Schaltungsanordnung wird der von dem Empfänger 13 kommende Strom I_{A}, oder die Spannung U_{A}, mit Hilfe eines Transformators in eine Spannung U'ᵢ überführt. Die in Fig.11e) dargestellte Schaltungsanordnung überführt den von dem Empfänger 13 kommende Strom I_{A}, oder die Spannung U_{A}, mit Hilfe eines Operationsversärker in die Spannung U'ᵢ.

Die Figuren 1, 7 und 10 veranschaulichen eine schematische Darstellung einer Positioniereinheit 2, bei der ein einzelner mehrschichtiger piezoelektrischer Aktuator 4, der gleichzeitig auch den Generator 12 sowie den Empfänger 13 bildet, zwischen Festkörpergelenken 9 angeordnet ist.

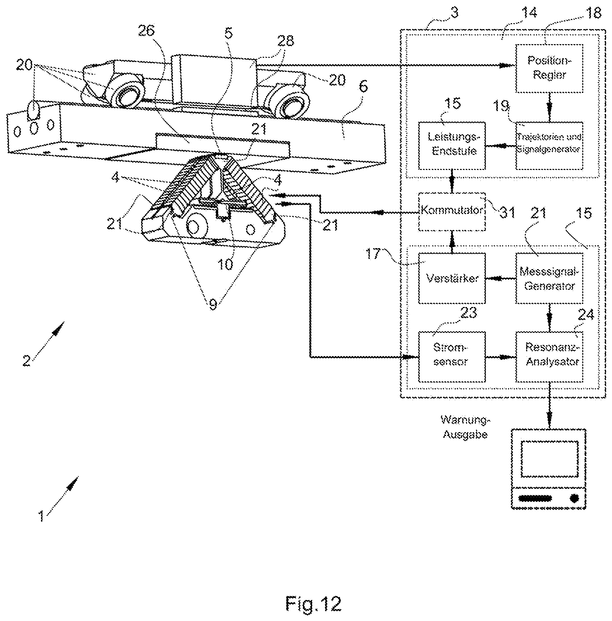

Fig. 12 zeigt eine schematische Darstellung einer Positioniereinheit 2 mit mehreren, d.h. insgesamt vier mehrschichtigen piezoelektrischen Multilayeraktuatoren 4, wobei jeder der Aktuatoren in bzw. zwischen Festkörpergelenken 9 angeordnet ist. Die Enden des jeweiligen Aktuators 4 liegen an Halteelementen 21 an. Die Bewegungsübertragung von dem Antriebselement 5 des Aktuators 4 auf das zu positionierende Element 6 findet über einen Reibkontakt statt, bei dem das Antriebselement 5 in Friktionskontakt mit einer Reibschiene 26 des zu positionierenden Elements 6 kommt bzw. steht. Das zu positionierende Element 6 ist hierbei über eine Führungsvorrichtung 20 linear gelagert und geführt. Ein Positionssensor 28 dient der Erfassung der Position des zu positionierenden Elements 6.

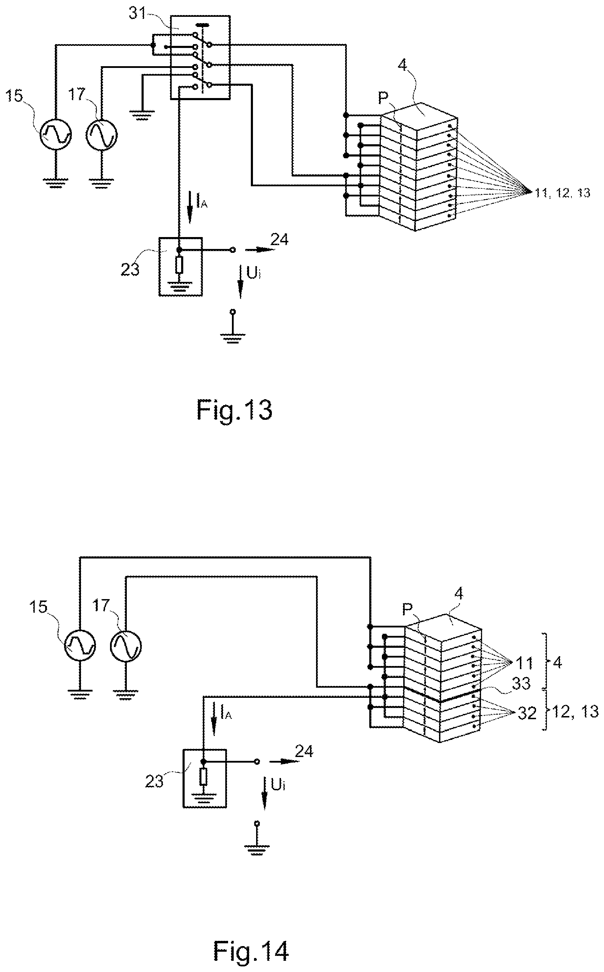

Fig. 13 veranschaulicht einen Aktuator 4 in Multilayerbauform, bei dem nur einige Schichten 11 für die Realisierung des Generators 12 und Empfängers 13 benutzt werden. Es ist denkbar, für die Realisierung des Generators 12 eine Anzahl von Schichten zu verwenden, die von der für die Realisierung des Empfängers 13 verwendeten Anzahl von Schichten abweicht. In der oberen Stellung des Kommutators 31 werden die Schichten des Aktuators an die Leistungsendstufe 15 angeschlossen. Der Aktuator befindet sich im Stellbetrieb- bzw. Antriebsmodus. Durch Umschalten in die untere Stellung werden die für die Funktion eines Generators bzw. die Funktion eines Empfängers vorgesehenen Schichten des Aktuators an die Leistungsendstufe angeschlossen und bilden dadurch in entsprechender Weise den Generator 12oder den Empfänger 13. Der Aktuatorstrom I_{A}, wird von dem Stromsensor 23 in die Spannung Uᵢ umgewandelt und weiter von dem Resonanzanalysator 24 verarbeitet.

Fig. 14 veranschaulicht eine beispielhafte Realisierung des Generators 12 oder Empfängers 13 als ein mit dem Aktuator verbundenes, jedoch selbst nicht aktuatorisch, d.h. eine Deformation bei Anlage einer elektrischen Spannung vollführend, wirkendes Teil. Die Schichten des Generators 12 und Empfängers 13 von akustischen Ultraschallwellen weisen eine zueinander entgegengesetzt gerichtete Polarisation auf. Der Generator 12 und der Empfänger 13 sind mit dem restlichen Teil des Aktuators über eine akustische Verbindung mit einem geringen akustischen Widerstand verbunden, so dass die akustischen Ultraschallwellen durch die Grenzschicht nicht wesentlich reflektiert oder gedämpft werden. Solch eine Verbindung ist beispielsweise durch das Sintern des Aktuators mit dem Generator oder Empfänger realisierbar. Ebenso ist es möglich, die Komponenten in einem Ofen durch leicht schmelzendes Glas oder einen ähnlichen harten Werkstoff zu verbinden.

Die Funktionsweise der erfindungsgemäßen Positioniervorrichtung 1 bzw. des erfindungsgemäßen Verfahrens wird anhand der Fig. 1 erläutert. In einem ersten Schritt wird eine Etalonmessung durchgeführt. Hierzu wird bei der ersten Inbetriebnahme der intakten Positioniereinheit 2 von der Defektanalysevorrichtung 16 deren Resonanzabbild aufgenommen. Dabei wird der piezoelektrische Aktuator 4 in seiner Funktion als Generator von akustischen Ultraschallwellen 12 von dem Messignalgenerator 22 mit einem elektrischen Messignal beaufschlagt. Das Messignal stellt eine elektrische Spannung mit einer Frequenz f dar. Die Messsignalspannung wird durch den Strom-Spannungsverstärker 17 verstärkt und über den Kommutator 31 an den Generator 12 weitergeleitet. Dadurch wird der Generator 12 angeregt und erzeugt Ultraschallwellen, die in die Positioniereinheit abgestrahlt werden. Durch die Ausbreitung der Ultraschallwellen werden in Komponenten der Positioniereinheit sowie in dem Aktuator selbst Resonanzschwingungen angeregt. Diese Resonanzschwingungen erzeugen wiederum akustische Ultraschallwellen, die den Empfänger 13 zusammen mit den reflektierten Ultraschallwellen erreichen und von ihm in Form einer Stromänderung erfasst werden.

Der Strom I_{A}, des Empfängers 13 gelangt zu dem Stromsensor 23 des Defektanalysators, wird von diesem in eine Spannung Uᵢ umgewandelt und an den Defektanalysator 16 weitergereicht. In dem Defektanalysator wird der Strom I_{A}, bzw. sein Abbild, die Spannung Uᵢ, die von dem Messignalgenerator 22 kommende Spannung U_{MS} sowie der Phasenwinkelwert *φ* zwischen dem Strom I_{A}, und der Spannung U_{MS} aufgezeichnet, gespeichert und daraus ein Resonanzabbild der Positioniereinheit erstellt.

Anschließend nimmt die Positioniereinheit ihren Betrieb auf, um vorgesehene Positionieraufgaben zu verrichten. Hierbei steuert der Trajektorien- und Signalgenerator 19 mit einem Steuersignal, verstärkt durch die Leistungsendstufe 15 bzw. über den Kommutator 31 geleitet, den Aktuator 4 an. Der Aktuator bringt das Antriebselement 5 und das damit gekoppelte, zu positionierende Element in eine Stellbewegung. Die Positionierung kann mit Hilfe des Positionssensors 28 durch den Regler 18 geregelt werden.

Nach einer bestimmten Betriebszeit wird eine Zustands- bzw. Defektdiagnose der Positioniereinheit vorgenommen. Hierzu wird eine Messung entsprechen dem ersten Schritt des erfindungsgemäßen Verfahrens durchgeführt. Der Generator 12 wird von dem Messignalgenerator 22 mit einem elektrischen Messignal beaufschlagt. Dadurch wird der Generator 12 angeregt und erzeugt Ultraschallwellen, die in die Positioniereinheit abgestrahlt werden. Durch die Ausbreitung der Ultraschallwellen werden in Komponenten der Positioniereinheit sowie in dem Aktuator selbst Resonanzschwingungen angeregt. Diese Resonanzschwingungen erzeugen wiederum akustische Ultraschallwellen, die den Empfänger 13 zusammen mit den reflektierten Ultraschallwellen erreichen und von ihm in Form von Stromänderung erfasst werden.

Der Strom I_{A}, des Empfängers 13 gelangt zu dem Stromsensor 23 des Defektanalysators, wird von diesem in eine Spannung Uᵢ umgewandelt und an den Defektanalysator 24 weitergereicht. In dem Defektanalysator wird der Strom I_{A}, bzw. sein Abbild, die Spannung Uᵢ, die von dem Messignalgenerator 22 kommende Spannung U_{MS} sowie der Phasenwinkelwert *φ* zwischen dem Strom I_{A}, und der Spannung U_{MS} aufgezeichnet, gespeichert und daraus ein Resonanzabbild der Positioniereinheit erstellt.

In einem darauffolgenden Verfahrensschritt werden in dem Resonanzanalysator 24 das aktuell erstellte Resonanzabbild der Positioniereinheit mit dem Resonanzabbild der intakten Positioniereinheit verglichen. Dabei wird das Vorhandensein einer neuen, die Veränderung oder das Fehlen zuvor existierender mechanischer Resonanzen bestimmt. Hierzu werden in dem Resonanzanalysator zweckmäßige Algorithmen implementiert, beispielsweise solche der neuronalen Netze. Bei Erkennung einer definierten Abweichung in der aktuellen Messung von der Etalonmessung, die auf einen baldigen Ausfall der Positioniereinheit hindeutet, wird von der Defektanalysevorrichtung eine Warnung ausgegeben.

Für das Erstellen des Resonanzabbild der Positioniereinheit können verschiedene vorteilhafte Verfahren angewendet werden. So kann die Positioniereinheit 2 von dem Messsinganalgenerator 22 mit einem elektrischen Messignal beaufschlagt werden, das eine elektrische Spannung mit einer veränderlichen Frequenz f darstellt (siehe hierzu Figs. 3und 4). Die Frequenz f ändert sich hierbei von einem Anfangs- zu einem Endwert. In dem Resonanzanalysator 24 wird der durch den Empfänger 13 fließende Strom I_{A} bzw. sein Abbild, die Spannung Uᵢ, die von dem Messignalgenerator 22 kommende Spannung U_{MS} sowie der Phasenwinkelwert *φ* zwischen dem Strom I_{A}, und der Spannung U_{MS} in Abhängigkeit von der Frequenz f aufgezeichnet. Aus den gespeicherten Messreihen wird zwecks Erkennung von Resonanzen der Positioniereinheit die Funktion des Impedanzbetrags |Z|=UA/IA von der Frequenz gebildet. Aus dem frequenzabhängigen Verlauf der Impedanz erstellt der Resonanzanalysator das Resonanzabbild der Positioniereinheit und erstellt eine Defektvorhersage bzw. Diagnose.

Weiterhin kann die Positioniereinheit 2 von dem Messsinganalgenerator 22 mit einem elektrischen Messignal beaufschlagt werden, das eine elektrische Spannung mit einer bestimmten Frequenz f darstellt. Das Resonanzabbild wird hierbei anhand Parameter einzelner Resonanzen durchgeführt (siehe hierzu Figs. 6 und Fig.7).

Bei einem weiteren vorteilhaften Verfahren wird die Positioniereinheit 2 von dem Messsinganalgenerator 22 mit einem elektrischen Messignal kurzer Dauer und mindestens einer bestimmten Frequenz f beaufschlagt. Das Resonanzabbild der Positioniereinheit wird anhand von Parametern der reflektierten Ultraschallwellen erstellt (siehe Fig. 8). Dabei werden von dem Resonanzanalysator die Dauer des reflektierten Impulses bzw. der reflektierten Impulse, die Amplitude, die Laufzeit oder die Form aufgezeichnet und analysiert.

Bei einem manuellen Erstellen des Resonanzabbildes der Positioniereinheit sowie seiner visuellen Analyse werden die Daten von der Defektanalysevorrichtung an den Computer 22 mit einem Bildschirm ausgegeben und von einem Bediener analysiert.

### Bezugszeichenliste:

1 Positioniervorrichtung
2 Positioniereinheit
3 Controller
4 Aktuator
5 Antriebselement
6 zu positionierendes Element
9 Festkörpergelenk
11 piezoelektrische Schichten (des Aktuators 4)
12 Generator akustischer Ultraschallwellen
13 Empfänger akustischer Ultraschallwellen
14 Steuer-Regelcontroller
15 Leistungsendstufe
16 Defektanalysevorrichtung
17 Strom- oder Spannungsverstärker
18 Regler der Position, Geschwindigkeit oder Beschleunigung
19 Trajektorien- und Signalgenerator
20 Führungsvorrichtung
21 Haltelement (des Aktuators 4)
22 Messsignalgenerator
23 Stromsensor
24 Resonanzanalysator
26 Reibschiene
28 Positionssensor
29 Computer
30 Integrierter Schaltkreis (z.B. FPGA, DSP)
31 Elektronischer Kommutator
32 Schichten des Generators und Empfängers von akustischen Ultraschallwellen
33 Verbindungsschicht des Aktuators mit dem Generator und Empfänger von akustischen Ultraschallwellen

## Patentansprüche

1. Positioniervorrichtung (1) mit einer Positioniereinheit (2), die einen piezoelektrischen Aktuator (4) umfasst, einem durch den Aktuator (4) bewegbaren Antriebselement (5), das zur Kopplung mit einem zu positionierenden Element (6) vorgesehen ist, und einem Controller (3), wobei die Positioniervorrichtung (1) eine Defektanalysevorrichtung (16) zum Erfassen von Defekten in der Positioniereinheit (2) aufweist, wobei im Falle, dass die Positioniereinheit (2) einen einzigen Aktuator (4) aufweist, dieser einen Generator (12) und einen Empfänger (13) akustischer Ultraschallwellen umfasst, und im Falle, dass die Positioniereinheit (2) mehrere Aktuatoren (4) aufweist, wenigstens einer der Aktuatoren (4) zumindest einen Generator (12) akustischer Ultraschallwellen umfasst und wenigstens ein anderer der Aktuatoren (4) zumindest einen Empfänger (13) akustischer Ultraschallwellen umfasst, und die Defektanalysevorrichtung (16) einen Messsignalgenerator (22) zur Erzeugung eines Messsignals in Form einer elektrischen Wechselspannung zur Anregung des oder eines Generators (12) aufweist,
**dadurch gekennzeichnet, dass** die Defektanalysevorrichtung (16) einen Resonanzanalysator (24) für die Analyse eines von dem oder einem Empfänger (13) erzeugten elektrischen Signals aufweist,
wobei der Resonanzanalysator (24) zur Vorhersage oder zum Erfassen von Defekten in der Positioniereinheit (2) derart konfiguriert ist, dass dieser aus dem Vergleich eines Resonanzbilds der Positioniereinheit (2) vor dem normalen Betrieb mit einem Resonanzbild während des normalen Betriebs die Entstehung von neuen oder das Verschwinden oder die Veränderung von zuvor existierenden Resonanzen erfasst und analysiert, wobei der Resonanzanalysator (24) konfiguriert ist, den Vergleich des Resonanzbilds vor dem normalen Betrieb mit einem Resonanzbild während des normalen Betriebs nach einer der folgenden Alternativen (A), (B), (C), (D), (E) auszuführen:
(A) der Messsignalgenerator (22) ist derart konfiguriert, dass dieser zur Ermittlung der Resonanzen, die zuvor vorhanden und jetzt verschwunden sind oder sich geändert haben, eine elektrische Sinusspannung erzeugt, deren Frequenz sich periodisch von einem Anfangs- zu einem Endwert ändert;
(B) der Messsignalgenerator (22) ist derart konfiguriert, dass der Frequenzwert des Messsignals gleich einem messbaren Resonanzfrequenzwert eines Aktuators (4) ist, wobei die Resonanzfrequenz zu den verschiedenen Arten von akustischen Ultraschallwellen gehört und wobei nach einem kurzen Anregen eines Generators (12) auf der Resonanzfrequenz das Abklingen der Positioniereinheit (2) über einen Empfänger (13) aufgenommen und danach zwecks Erfassung einer Resonanzveränderung die aufgezeichnete Abklingkurve mit einer zu einer früheren Zeit aufgenommenen Abklingkurve verglichen wird;
(C) der Messsignalgenerator (22) ist derart konfiguriert, dass der Frequenzwert des Messsignals gleich einem messbaren Resonanzfrequenzwert der Positioniereinheit (2) ist, wobei nach einem kurzen Anregen eines Generators (12) das Abklingverhalten der Positioniereinheit (2) zwecks Erfassung einer Resonanzveränderung aufgezeichnet und mit einem zu einer früheren Zeit aufgenommenen Abklingverhalten verglichen wird;
(D) der Messsignalgenerator (22) ist derart konfiguriert, dass der Frequenzwert des Messsignals gleich mindestens einem messbaren Resonanzfrequenzwert der Positioniereinheit (2) ist, wobei während des Anregens eines Generators (12) zwecks Erfassung mindestens einer Resonanzveränderung der innere Widerstand Rᵢ=U_{A}/I_{A} der Positioniereinheit (2) bestimmt und mit einem zu einer früheren Zeit aufgenommenen Wert des inneren Widerstands der Positioniereinheit (2) verglichen wird;
(E) der Messsignalgenerator (22) ist derart konfiguriert, dass der Frequenzwert des Messsignals im Wesentlichen gleich einem messbaren Resonanzfrequenzwert der Positioniereinheit (2) ist, und dabei während oder nach einem kurzen Anregen eines Generators (12) der reflektierte Impuls von einem Empfänger (13) aufgenommen wird, wobei Parameter des reflektierten Impulses zwecks Erfassung einer Resonanzveränderung aufgezeichnet und mit zu einer früheren Zeit aufgenommenen Parametern verglichen werden.

2. Positioniervorrichtung (1) nach Anspruch 1, **dadurch gekennzeichnet, dass** der Messsignalgenerator (22) nach der Alternative (A) und derart konfiguriert ist, dass dieser die Frequenz des Messsignals von einem Anfangs- zu einem Endwert verändert und dabei den durch einen Empfänger (13) fließenden Stromwert sowie den Phasenwinkelwert zwischen dem Strom und der Spannung in Form einer Abhängigkeit von der Frequenz misst und zusammen mit der Spannung aufzeichnet, und dass der Resonanzanalysator (24) derart konfiguriert ist, dass dieser aus den Messreihen zur Detektion von Resonanzen die Funktion des Impedanzbetrags |Z| von der Frequenz bildet und aus der Impedanz das Vorhandensein neuer oder die Veränderung oder das Fehlen zuvor detektierter mechanischer Resonanzen bestimmt.

3. Positioniervorrichtung (1) nach einem der vorhergehenden Ansprüche, **dadurch gekennzeichnet, dass** die Defektanalysevorrichtung (16) einen Generator für weißes Rauschen umfasst.

4. Positioniervorrichtung (1) nach einem der vorhergehenden Ansprüche, **dadurch gekennzeichnet, dass** die Defektanalysevorrichtung (16) zur Erfassung eines von einem Empfänger (13) erzeugten elektrischen Signals einen Stromsensor (23) aufweist, wobei zur Detektion eines Stroms ein Widerstand, ein Transistor, ein Transformator, ein Optokoppler oder ein Operationsverstärker dient.

5. Positioniervorrichtung (1) nach einem der vorhergehenden Ansprüche, **dadurch gekennzeichnet, dass** ein Aktuator (4) als mehrschichtiger piezoelektrischer Aktuator ausgebildet ist.

6. Positioniervorrichtung (1) nach einem der vorhergehenden Ansprüche, **dadurch gekennzeichnet, dass** ein Generator (12) oder ein Empfänger (13) einen Teil eines Aktuators (4) bildet und keine aktuatorische Funktion aufweist.

7. Positioniervorrichtung (1) nach Anspruch 6, **dadurch gekennzeichnet, dass** der einen Generator (12) oder einen Empfänger (13) ausbildende Teil eines Aktuators (4) mit dem restlichen Teil desselben Aktuators (4) durch eine akustische Verbindung mit einem geringen akustischen Widerstand verbunden ist.

8. Positioniervorrichtung (1) nach einem der vorhergehenden Ansprüche, **dadurch gekennzeichnet, dass** ein Generator (12) in einem Aktuator (4) ausgebildet ist und ein Empfänger (13) in einem anderen und beabstandeten Aktuator ausgebildet ist.

9. Verfahren zum Betreiben der Positioniervorrichtung (1) mit einer Positioniereinheit (2), die einen piezoelektrischen Aktuator (4) umfasst, einem durch den Aktuator (4) bewegbaren Antriebselement (5), das zur Kopplung mit einem zu positionierenden Element (6) vorgesehen ist, und einem Controller (3), wobei die Positioniervorrichtung (1) eine Defektanalysevorrichtung (16) zum Erfassen von Defekten in der Positioniereinheit (2) aufweist, wobei im Falle, dass die Positioniereinheit (2) einen einzigen Aktuator (4) aufweist, dieser einen Generator (12) und einen Empfänger (13) akustischer Ultraschallwellen umfasst, und im Falle, dass die Positioniereinheit (2) mehrere Aktuatoren (4) aufweist, wenigstens einer der Aktuatoren (4) zumindest einen Generator (12) akustischer Ultraschallwellen umfasst und wenigstens ein anderer der Aktuatoren (4) zumindest einen Empfänger (13) akustischer Ultraschallwellen umfasst, und die Defektanalysevorrichtung (16) einen Messsignalgenerator (22) zur Erzeugung eines Messsignals in Form einer elektrischen Wechselspannung zur Anregung des oder eines Generators (12) aufweist, **dadurch gekennzeichnet, dass** die Defektanalysevorrichtung (16) einen Resonanzanalysator (24) für die Analyse eines von dem oder einem Empfänger (13) erzeugten elektrischen Signals aufweist,
wobei ein Generator (12) periodisch mit einem elektrischen Messsignal des Messsignalgenerators (22) in Form einer elektrischen Wechselspannung beaufschlagt wird, und mechanische Resonanzen der Positioniereinheit (2) mit einem Empfänger (13) periodisch aufgenommen werden, und durch den Resonanzanalysator (24) mittels eines Vergleichs von einem Resonanzbild der Positioniereinheit (2) vor dem normalen Betrieb mit einem Resonanzbild der Positioniereinheit (2) während des normalen Betriebs die Entstehung von neuen oder das Verschwinden oder die Veränderung von zuvor existierenden Resonanzen erfasst und analysiert werden zur Vorhersage oder zum Erfassen von Defekten in der Positioniereinheit (2), wobei der Vergleich des Resonanzbilds vor dem normalen Betrieb mit einem Resonanzbild während des normalen Betriebs nach einer der folgenden Alternativen (A), (B), (C), (D), (E) erfolgt:
(A) der Messsignalgenerator (22) erzeugt zur Ermittlung der Resonanzen, die zuvor vorhanden und jetzt verschwunden sind oder sich geändert haben, eine elektrische Sinusspannung, deren Frequenz sich periodisch von einem Anfangszu einem Endwert ändert;
(B) der Messsignalgenerator (22) erzeugt ein Messsignal, dessen Frequenzwert gleich einem messbaren Resonanzfrequenzwert eines Aktuators (4) ist, wobei die Resonanzfrequenz zu den verschiedenen Arten von akustischen Ultraschallwellen gehört und wobei nach einem kurzen Anregen eines Generators (12) auf der Resonanzfrequenz das Abklingen der Positioniereinheit (2) über einen Empfänger (13) aufgenommen und danach zwecks Erfassung einer Resonanzveränderung die aufgezeichnete Abklingkurve mit einer zu einer früheren Zeit aufgenommenen Abklingkurve verglichen wird;
(C) der Messsignalgenerator (22) erzeugt ein Messsignal, dessen Frequenzwert des Messsignals gleich einem messbaren Resonanzfrequenzwert der Positioniereinheit (2) ist, wobei nach einem kurzen Anregen eines Generators (12) das Abklingverhalten der Positioniereinheit (2) zwecks Erfassung einer Resonanzveränderung aufgezeichnet und mit einem zu einer früheren Zeit aufgenommenen Abklingverhalten verglichen wird;
(D) der Messsignalgenerator (22) erzeugt ein Messsignal, dessen Frequenzwert des Messsignals gleich mindestens einem messbaren Resonanzfrequenzwert der Positioniereinheit (2) ist, wobei während des Anregens eines Generators (12) zwecks Erfassung mindestens einer Resonanzveränderung der innere Widerstand Rᵢ=U_{A}/I_{A} der Positioniereinheit (2) bestimmt und mit einem zu einer früheren Zeit aufgenommenen Wert des inneren Widerstands der Positioniereinheit (2) verglichen wird;
(E) der Messsignalgenerator (22) erzeugt ein Messsignal, dessen Frequenzwert des Messsignals im Wesentlichen gleich einem messbaren Resonanzfrequenzwert der Positioniereinheit (2) ist, und dabei während oder nach einem kurzen Anregen eines Generators (12) der reflektierte Impuls von einem Empfänger (13) aufgenommen wird, wobei Parameter des reflektierten Impulses zwecks Erfassung einer Resonanzveränderung aufgezeichnet und mit zu einer früheren Zeit aufgenommenen Parametern verglichen werden.

10. Verfahren nach Anspruch 9, **dadurch gekennzeichnet, dass** in der Alternative (A) die Frequenz des Messsignals von einem Anfangs- zu einem Endwert verändert und dabei der durch einen Empfänger (13) fließende Stromwert sowie ein Phasenwinkelwert zwischen dem Strom und der Spannung in Form einer Abhängigkeit von der Frequenz gemessen und zusammen mit der Spannung aufgezeichnet wird, und aus den Messreihen zur Detektion von Resonanzen die Funktion eines Impedanzbetrags |Z| in Abhängigkeit von der Frequenz gebildet wird, und aus dem Impedanzbetrag |Z| das Vorhandensein neuer oder die Veränderung oder das Fehlen zuvor detektierter mechanischer Resonanzen bestimmt wird.

11. Verfahren nach Anspruch 9 oder 10, **dadurch gekennzeichnet, dass** in der Alternative (A) die Funktion des Impedanzbetrags |Z| in Abhängigkeit von der Frequenz mit dem Phasenwinkel in einem Nyquist-Diagramm dargestellt wird, aus dem das Vorhandensein neuer oder die Veränderung oder das Fehlen zuvor detektierter mechanischer Resonanzen bestimmt wird.

12. Verfahren nach einem der Ansprüche 9 bis 11, **dadurch gekennzeichnet, dass** in der Alternative (A) der Frequenzanfangswert des Messsignals gleich dem niedrigsten nachweisbaren Resonanzfrequenzwert eines Aktuators (4) ist und der Frequenzendwert des Messsignals gleich dem Resonanzfrequenzwert der höchsten messbaren Resonanz eines Aktuators (4) ist, wobei sowohl der niedrigste Resonanzfrequenzwert als auch der höchste Resonanzfrequenzwert zu den unterschiedlichen Arten von akustischen Ultraschallwellen gehören.

13. Verfahren nach einem der Ansprüche 9 bis 12, **dadurch gekennzeichnet, dass** in der Alternative (A) der Frequenzanfangswert des Messsignals dem niedrigsten Resonanzfrequenzwert eines Aktuators (4) entspricht, der durch seine Länge bestimmt ist, und der Frequenzendwert des Messsignals gleich dem doppelten Resonanzfrequenzwert entspricht, der durch die Hälfte der Aktuatorlänge bestimmt ist.

14. Verfahren nach einem der Ansprüche 9 bis 13, **dadurch gekennzeichnet, dass** in der Alternative (A) die Frequenz des Messsignals von dem Anfangs- bis zu dem Endwert logarithmisch verändert wird.

## Claims

1. Positioning device (1), comprising a positioning unit (2) with a piezoelectric actuator (4), a drive element (5) movable by the actuator (4) and provided for coupling to an element (6) to be positioned, and a controller (3), wherein the positioning device (1) comprises a defect analysis device (16) for detecting defects in the positioning unit (2), wherein, in the case that the positioning unit (2) comprises a single actuator (4), the actuator (4) comprises a generator (12) and a receiver (13) of acoustic ultrasonic waves, and, in the case that the positioning unit (2) comprises a plurality of actuators (4), at least one of the actuators (4) comprises at least one generator (12) of ultrasonic acoustic waves and at least another one of the actuators (4) comprises at least one receiver (13) of ultrasonic acoustic waves, and wherein the defect analysis device (16) comprises a measurement signal generator (22) for generating a measurement signal in form of an electric voltage for exciting the or a generator (12),
**characterized in that** the defect analysis device (16) comprises a resonance analyzer (24) for analyzing an electric signal generated by the or a receiver (13),
wherein, for predicting or detecting defects arising within the positioning unit, the resonance analyzer (24) is configured such that the same determines and analyzes the emergence of new resonances or the disappearance or change of previously existing resonances by comparing a resonance image before normal operation with a resonance image during normal operation, wherein the resonance analyzer (24) is configured to carry out the comparison of the resonance image before normal operation with a resonance image during normal operation according to one of the following alternatives (A), (B), (C), (D), (E):
(A) the measurement signal generator (22) is configured such that, in order to determine the resonances which were previously existing and have now disappeared or have changed, it generates an electrical sinusoidal voltage whose frequency changes periodically from an initial to a final value,
(B) the measurement signal generator (22) is configured such that the frequency value of the measurement signal is equal to a measurable resonance frequency value of an actuator (4), wherein said resonance frequency belongs to the various types of ultrasonic acoustic waves and wherein after a short excitation of a generator (12) at the resonance frequency, the decay of the positioning unit (2) is recorded via a receiver (13) and thereafter, for the purpose of detecting a resonance change, the recorded decay curve is compared with a decay curve recorded at an earlier time;
(C) the measurement signal generator (22) is configured such that the frequency value of the measurement signal is equal to a measurable resonance frequency value of the positioning unit (2), wherein after a short excitation of a generator (12) the decay behavior of the positioning unit (2) is recorded for the purpose of detecting a resonance change and compared with a decay behavior recorded at an earlier time;
(D) the measurement signal generator (22) is configured such that the frequency value of the measurement signal is equal to at least one measurable resonance frequency value of the positioning unit (2), wherein during the excitation of a generator (12) for the purpose of detecting at least one resonance change, the internal resistance Rᵢ=U_{A}/I_{Ar} of the positioning unit (2) is determined and compared with a value of the internal resistance of the positioning unit (2) recorded at an earlier time;
(E) the measurement signal generator (22) is configured such that the frequency value of the measurement signal is substantially equal to a measurable resonance frequency value of the positioning unit (2), and in this case, during or after a short excitation of a generator (12), the reflected pulse is picked up by a receiver (13), parameters of the reflected pulse being recorded for detecting a resonance change and being compared with parameters recorded at an earlier time.

2. Positioning device (1) according to claim 1, **characterized in that** the measurement signal generator (22) is configured according to alternative (A) and such that it changes the frequency of the measurement signal from an initial value to a final value and, in the process, measures the current value flowing through a receiver (13) and the phase angle value between the current and the voltage in the form of a function of the frequency and records it together with the voltage, and **in that** the resonance analyzer (24) is configured such that, from the series of measurements for detecting resonances, the function of the impedance magnitude |Z| is formed as a function of the frequency, and from the impedance the presence of new or the change or absence of previously detected mechanical resonances is determined.

3. Positioning device (1) according to any one of the preceding claims, **characterized in that** the defect analysis device (16) comprises a white noise generator.

4. Positioning device (1) according to any one of the preceding claims, **characterized in that** the defect analysis device (16) comprises a current sensor (23) for detecting an electrical signal generated by a receiver (13), wherein a resistor, a transistor, a transformer, an optocoupler or an operational amplifier is used for detecting a current.

5. Positioning device (1) according to any one of the preceding claims, **characterized in that** an actuator (4) is designed as a multilayer piezoelectric actuator.

6. Positioning device (1) according to any of the preceding claims, **characterized in that** a generator (12) or a receiver (13) forms part of an actuator (4) and comprises no actuating function.

7. Positioning device (1) according to claim 6, **characterized in that** the part of an actuator (4) forming a generator (12) or a receiver (13) is connected to the remaining part of the same actuator (4) by an acoustic connection with a low acoustic resistance.

8. Positioning device (1) according to any one of the preceding claims, **characterized in that** a generator (12) is formed in one actuator (4) and a receiver (13) is formed in another and spaced actuator.

9. Method for operating the positioning device (1) comprising a positioning unit (2) with a piezoelectric actuator (4), a drive element (5) which movable by the actuator (4) and which is provided for coupling to an element (6) to be positioned, and a controller (3), wherein the positioning device (1) comprises a defect analysis device (16) for detecting defects in the positioning unit (2), wherein, in the case that the positioning unit (2) comprises a single actuator (4), the actuator (4) comprises a generator (12) and a receiver (13) of acoustic ultrasonic waves and, in the case that the positioning unit (2) comprises a plurality of actuators (4), at least one of the actuators (4) comprises at least one generator (12) of ultrasonic acoustic waves and at least another one of the actuators (4) comprises at least one receiver (13) of ultrasonic acoustic waves, and wherein the defect analysis device (16) comprises a measurement signal generator (22) for generating a measurement signal in form of an electric voltage for exciting the or a generator (12), **characterized in that** the defect analysis device (16) comprises a resonance analyzer (24) for analyzing an electric signal generated by the or a receiver (13),
wherein a generator (12) is periodically supplied with an electrical measuring signal of the measuring signal generator (22) in the form of an electrical alternating voltage and wherein mechanical resonances of the positioning unit (2) are periodically picked up with a receiver (13), and wherein by means of the resonance analyzer (24) comparing a resonance image of the positioning unit (2) before normal operation with a resonance image of the positioning unit (2) during normal operation the emergence of new or the disappearance or the change of previously existing resonances are detected and analyzed for predicting or detecting defects in the positioning unit (2), wherein the comparison of the two resonance images comparing the resonance image made before normal operation with the resonance image made during operation is carried out according to one of the following alternatives (A), (B), (C), (D), (E):
(A) the measurement signal generator (22), for determining the resonance image, generates an electrical sinusoidal voltage, the frequency of which changing periodically from an initial to a final value,
(B) the measurement signal generator (22) generates a measurement signal, the frequency value of which is equal to a measurable resonance frequency value of an actuator (4), wherein said resonance frequency belongs to the various types of ultrasonic acoustic waves and wherein after a short excitation of a generator (12) at the resonance frequency, the decay of the positioning unit (2) is recorded via a receiver (13) and thereafter, for the purpose of detecting a resonance change, the recorded decay curve is compared with a decay curve recorded at an earlier time;
(C) the measurement signal generator (22) generates a measurement signal, the frequency value of which is equal to a measurable resonance frequency value of the positioning unit (2), wherein after a short excitation of a generator (12) the decay behavior of the positioning unit (2) is recorded for the purpose of detecting a resonance change and compared with a decay behavior recorded at an earlier time;
(D) the measurement signal generator (22) generates a measurement signal, the frequency value of which is equal to at least one measurable resonance frequency value of the positioning unit (2), wherein during the excitation of a generator (12) for the purpose of detecting at least one resonance change, the internal resistance Rᵢ=U_{A}/I_{Ar} of the positioning unit (2) is determined and compared with a value of the internal resistance of the positioning unit (2) recorded at an earlier time;
(E) the measurement signal generator (22) generates a measurement signal, the frequency value of which is substantially equal to a measurable resonance frequency value of the positioning unit (2) and in this case, during or after a short excitation of a generator (12), the reflected pulse is picked up by a receiver (13), parameters of the reflected pulse being recorded for detecting a resonance change and being compared with parameters recorded at an earlier time.

10. A method according to claim 9, **characterized in that**, in alternative (A), the frequency of the measurement signal is changed from an initial to a final value, and thereby the current value flowing through a receiver (13) and a phase angle value between the current and the voltage are measured in the form of a dependency of the frequency and recorded together with the voltage, and from the series of measurements for detecting resonances the function of an impedance |Z| in dependency of the frequency is formed, and from the impedance amount |Z| the presence of new or the change or absence of previously detected mechanical resonances is determined.

11. A method according to claim 9 or 10, **characterized in that**, in alternative (A), the function of the impedance amount |Z| in dependency of the frequency with the phase angle is represented in a Nyquist diagram, from which the presence of new or the change or the absence of previously detected mechanical resonances is determined.

12. Method according to any one of claims 9 to 11, **characterized in that**, in alternative (A), the initial frequency value of the measurement signal is equal to the lowest detectable resonance frequency value of an actuator (4) and the final frequency value of the measurement signal is equal to the resonance frequency value of the highest measurable resonance of an actuator (4), wherein both the lowest resonance frequency value and the highest resonance frequency value belong to the different types of ultrasonic acoustic waves.

13. A method according to any one of claims 9 to 12, **characterized in that**, in alternative (A), the initial frequency value of the measurement signal corresponds to the lowest resonance frequency value of an actuator (4) determined by its length, and the final frequency value of the measurement signal corresponds to twice the resonance frequency value determined by half the actuator length.

14. A method according to any one of claims 9 to 13, **characterized in that**, in alternative (A), the frequency of the measurement signal is logarithmically varied from the initial to the final value.

## Revendications

1. Dispositif de positionnement (1) pourvu d'une unité de positionnement (2) qui comprend un actionneur (4) piézoélectrique, d'un élément d'entraînement (5), déplaçable par l'actionneur (4), qui est prévu pour être accouplé avec l'élément (6) qui doit être positionné et d'un contrôleur (3), le dispositif de positionnement (1) comportant un dispositif d'analyse des défectuosités (16), destiné à détecter des défectuosités dans l'unité de positionnement (2), dans le cas où l'unité de positionnement (2) ne comporte qu'un seul actionneur (4), celui-ci comprenant un générateur (12) et un récepteur (13) d'ondes acoustiques ultrasoniques et dans le cas où l'unité de positionnement (2) comporte plusieurs actionneurs (4), au moins l'un des actionneurs (4) comprenant au moins un générateur (12) d'ondes acoustiques ultrasoniques et au moins un autre des actionneurs (4) comprenant au moins un récepteur (13) d'ondes acoustiques ultrasoniques et le dispositif d'analyse des défectuosités (16) comportant un générateur (22) de signaux de mesure, destiné à générer un signal de mesure sous la forme d'une tension électrique alternative, visant à exciter le ou un générateur (12),
**caractérisé en ce que** le dispositif d'analyse des défectuosités (16) comporte un analyseur de résonance (24) pour l'analyse d'un signal électrique généré par le ou par un récepteur (13),
pour prédire ou pour détecter des défectuosités dans l'unité de positionnement (2), l'analyseur de résonance (24) étant configuré de sorte à détecter sur la base de la comparaison d'une image de résonance de l'unité de positionnement (2) avant le fonctionnement normal avec une image de résonance en cours de fonctionnement normal la naissance de nouvelles résonances ou la disparition de résonances ou la variation de résonances préalablement existantes et à les analyser, l'analyseur de résonance (24) étant configuré pour procéder à la comparaison de l'image de résonance avant le fonctionnement normal avec une image de résonance pendant le fonctionnement normal selon l'une des alternatives (A), (B), (C), (D), (E) suivantes :
(A) le générateur (22) de signaux de mesure est configuré de telle sorte que pour déterminer les résonances, préalablement présentes et maintenant disparues ou qui ont subi une variation, il génère une tension électrique sinusoïdale dont la fréquence varie périodiquement d'une valeur initiale à une valeur finale ;
(B) le générateur (22) de signaux de mesure est configuré de telle sorte qu'une valeur de fréquence du signal de mesure soit égale à une valeur de fréquence de résonance mesurable d'un actionneur (4), la fréquence de résonance appartenant aux différents types d'ondes acoustiques ultrasoniques et qu'après une brève excitation d'un générateur (12) à la fréquence de résonance , l'affaiblissement de l'unité de positionnement (2) soit enregistré via un récepteur (13) et qu'ensuite, pour détecter un variation de résonance, la courbe d'affaiblissement enregistrée soit comparée avec une courbe d'affaiblissement enregistrée à un moment antérieur ;
(C) le générateur (22) de signaux de mesure est configuré de telle sorte que la valeur de fréquence de signal de mesure soit égale à une valeur de fréquence de résonance mesurable de l'unité de positionnement (2), après une brève excitation d'un générateur (12), le comportement d'affaiblissement de l'unité de positionnement (2) étant enregistré pour détecter une variation de résonance et comparé avec un comportement d'affaiblissement enregistré à un moment antérieur;
(D) le générateur (22) de signaux de mesure est configuré de telle sorte que la valeur de fréquence du signal de mesure soit égale à au moins une valeur de fréquence de résonance mesurable de l'unité de positionnement (2), pendant l'excitation d'un générateur (12), pour détecter au moins une variation de résonance , la résistance interne Rᵢ=U_{A}/I_{A} de l'unité de positionnement (2) étant déterminée et comparée avec une valeur de la résistance interne de l'unité de positionnement (2) enregistrée à un moment antérieur ;
(E) le générateur (22) de signaux de mesure est configuré de telle sorte que la valeur de fréquence du signal de mesure soit sensiblement égale à une valeur de fréquence de résonance mesurable de l'unité de positionnement (2) et qu'à cet effet, pendant ou après une brève excitation d'un générateur (12), l'impulsion réfléchie soit enregistrée par un récepteur (13), pour détecter une variation de résonance, des paramètres de l'impulsion réfléchie étant enregistrés et comparés avec des paramètres enregistrés à un moment antérieur.

2. Dispositif de positionnement (1) selon la revendication 1, **caractérisé en ce que** le générateur (22) de signaux de mesure est configuré selon l'alternative (A) et de sorte à faire varier la fréquence du signal de mesure d'une valeur initiale à une valeur finale et à mesurer à cet effet la valeur de courant circulant à travers un récepteur (13), ainsi que la valeur d'angle de phase entre le courant et la tension sous la forme d'une dépendance de la fréquence et à l'enregistrer conjointement avec la tension et **en ce que** pour détecter des résonances, l'analyseur de résonance (24) est configuré de sorte à constituer à partir des séries de mesure la fonction du montant de l'impédance |Z| de la fréquence et à déterminer à partir de l'impédance la présence de nouvelles impédances ou la variation ou l'absence de résonances mécaniques précédemment détectées.

3. Dispositif de positionnement (1) selon l'une quelconque des revendications précédentes, **caractérisé en ce que** dispositif d'analyse des défectuosités (16) comprend un générateur pour des bruits blancs.

4. Dispositif de positionnement (1) selon l'une quelconque des revendications précédentes, **caractérisé en ce que** pour détecter un signal électrique généré par un récepteur (13), le dispositif d'analyse des défectuosités (16), comporte un capteur de courant (23), une résistance, un transistor, un transformateur, un optocoupleur ou un amplificateur opérationnel servant à détecter un courant.

5. Dispositif de positionnement (1) selon l'une quelconque des revendications précédentes, **caractérisé en ce qu'**un actionneur (4) est conçu sous la forme d'un actionneur piézoélectrique multicouches.

6. Dispositif de positionnement (1) selon l'une quelconque des revendications précédentes, **caractérisé en ce qu'**un générateur (12) ou un récepteur (13) constitue une partie d'un actionneur (4) et n'assure aucune fonction d'actionnement

7. Dispositif de positionnement (1) selon la revendication 6, **caractérisé en ce que** la partie d'un actionneur (4) constituant un générateur (12) ou un récepteur (13) est connectée avec la partie restante dudit actionneur (4) par une connexion de faible résistance acoustique.

8. Dispositif de positionnement (1) selon l'une quelconque des revendications précédentes, **caractérisé en ce qu'**un générateur (12) est conçu dans un actionneur (4) et un récepteur (13) est conçu dans un actionneur différent et distant.

9. Procédé opérationnel du dispositif de positionnement (1), pourvu d'une unité de positionnement (2) qui comprend un actionneur (4) piézoélectrique, d'un élément d'entraînement (5), déplaçable par l'actionneur (4) , qui est prévu pour être accouplé avec l'élément (6) qui doit être positionné et d'un contrôleur (3), le dispositif de positionnement (1) comportant un dispositif d'analyse des défectuosités (16), destiné à détecter des défectuosités dans l'unité de positionnement (2) , dans le cas où l'unité de positionnement (2) ne comporte qu'un seul actionneur (4), celui-ci comprenant un générateur (12) et un récepteur (13) d'ondes acoustiques ultrasoniques et dans le cas où l'unité de positionnement (2) comporte plusieurs actionneurs (4), au moins l'un des actionneurs (4) comprenant au moins un générateur (12) d'ondes acoustiques ultrasoniques et au moins un autre des actionneurs (4) comprenant au moins un récepteur (13) d'ondes acoustiques ultrasoniques et le dispositif d'analyse des défectuosités (16) comportant un générateur (22) de signaux de mesure, destiné à générer un signal de mesure sous la forme d'une tension électrique alternative, visant à exciter le ou un générateur (12), **caractérisé en ce que** le dispositif d'analyse des défectuosités (16) comporte un analyseur de résonance (24), destiné à analyser un signal électrique généré par le ou par un récepteur (13),
le générateur (12) étant exposé périodiquement à un signal de mesure du générateur (22) de signaux de mesure, sous la forme d'une tension électrique alternative et des résonances mécaniques de l'unité de positionnement (2) étant périodiquement enregistrées par un récepteur (13) et par l'analyseur de résonance (24), au moyen d'une comparaison d'une image de résonance de l'unité de positionnement (2) avant le fonctionnement normal avec une image de résonance de l'unité de positionnement (2) pendant le fonctionnement normal, la naissance de résonances ou la disparition ou la variation de résonances préalablement existantes étant détectée et analysée, pour prédire ou pour détecter des défectuosités dans l'unité de positionnement (2), la comparaison de l'image de résonance avant le fonctionnement normal avec une image de résonance pendant le fonctionnement normal s'effectuant selon l'une des alternatives (A), (B), (C), (D), (E) suivantes :
(A) pour déterminer les résonances qui étaient préalablement présentes et qui ont maintenant disparu ou qui ont subi une variation, le générateur (22) de signaux de mesure génère une tension électrique sinusoïdale dont la fréquence varie périodiquement d'une valeur initiale à une valeur finale ;
(B) le générateur (22) de signaux de mesure génère un signal de mesure, dont la valeur de fréquence est égale à une valeur de fréquence de résonance mesurable d'un actionneur (4), la fréquence de résonance appartenant aux différents types de valeurs acoustiques ultrasonores et après une brève excitation d'un générateur (12) à la fréquence de résonance, l'affaiblissement de l'unité de positionnement (2) étant enregistrée via un récepteur (13) et ensuite, pour détecter une variation de résonance, la courbe d'affaiblissement enregistrée étant comparée avec une courbe d'affaiblissement enregistrée à un moment antérieur ;
(C) le générateur (22) de signaux de mesure génère un signal de mesure, dont la valeur de fréquence du signal de mesure est égale à une valeur de fréquence de résonance mesurable de l'unité de positionnement (2), pour détecter une variation de résonance, après une brève excitation d'un générateur (12) à la fréquence de résonance, la courbe d'affaiblissement de l'unité de positionnement (2) étant enregistrée et comparée avec un comportement d'affaiblissement enregistré à un moment antérieur ;
(D) le générateur (22) de signaux de mesure génère un signal de mesure, dont la valeur de fréquence du signal de mesure est égale à au moins une valeur de fréquence de résonance mesurable de l'unité de positionnement (2), pendant l'excitation d'un générateur (12), pour détecter au moins une variation de résonance , la résistance interne Rᵢ=U_{A}/I_{A} de l'unité de positionnement (2) étant déterminée et comparée avec une valeur de la résistance interne de l'unité de positionnement (2) enregistrée à un moment antérieur ;
(E) le générateur (22) de signaux de mesure génère un signal de mesure, dont la valeur de fréquence du signal de mesure est sensiblement égale à une valeur de fréquence de résonance mesurable de l'unité de positionnement (2) et à cet effet, pendant ou après une brève excitation d'un générateur (12), l'impulsion réfléchie est enregistrée par un récepteur (13), pour détecter une variation de résonance, des paramètres de l'impulsion réfléchie étant enregistrés et comparés avec des paramètres enregistrés à un moment antérieur.

10. Procédé selon la revendication 9, **caractérisé en ce que** dans l'alternative (A), la fréquence du signal de mesure varie d'une valeur initiale à une valeur finale et à cet effet, la valeur de courant circulant à travers un récepteur (13), ainsi qu'une valeur d'angle de phase entre le courant et la tension étant mesurées sous la forme d'une dépendance de la fréquence et enregistrées conjointement avec la tension et à partir des séries de mesure, pour détecter des résonances, la fonction d'un montant d'impédance |Z| étant constituée selon la fréquence et à partir du montant d'impédance |Z| , la présence de nouvelles résonances ou la variation ou l'absence de résonances mécaniques précédemment détectées étant déterminée.

11. Procédé selon la revendication 9 ou 10, **caractérisé en ce que** dans l'alternative (A), la fonction du montant d'impédance |Z| selon la fréquence est représentée avec l'angle de phase dans un diagramme de Nyquist, à partir duquel la présence de nouvelles résonances mécaniques ou la variation ou l'absence de résonances précédemment détectées est déterminée.

12. Procédé selon l'une quelconque des revendications 9 à 11, **caractérisé en ce que** dans l'alternative (A), la valeur initiale de fréquence du signal de mesure est égale à la plus basse valeur de fréquence de résonance décelable d'un actionneur (4) et la valeur finale de fréquence du signal de mesure est égale à la valeur de fréquence de résonance de la plus haute résonance mesurable d'un actionneur (4), aussi bien la plus basse valeur de fréquence de résonance qu'également la plus haute valeur de fréquence de résonance appartenant aux différents types d'ondes acoustiques ultrasoniques.

13. Procédé selon l'une quelconque des revendications 9 à 12, **caractérisé en ce que** dans l'alternative (A), la valeur initiale de fréquence du signal de mesure correspond à la plus basse valeur de fréquence de résonance d'un actionneur (4) qui est déterminée par sa longueur et la valeur finale de fréquence du signal de mesure est égale à la double valeur de fréquence de résonance qui est déterminée par la moitié de la longueur de l'actionneur.

14. Procédé selon l'une quelconque des revendications 9 à 13, **caractérisé en ce que** dans l'alternative (A), l'on fait varier de manière logarithmique la fréquence du signal de mesure de la valeur initiale à la valeur finale.
